(19) Europäisches Patentamt
European Patent Office
Office européen des brevets

(11) **EP 2 197 037 A1**

(12) **EUROPEAN PATENT APPLICATION**
published in accordance with Art. 153(4) EPC

(43) Date of publication:
**16.06.2010 Bulletin 2010/24**

(51) Int Cl.:
***H01L 31/04*** *(2006.01)*

(21) Application number: **08833412.3**

(22) Date of filing: **26.09.2008**

(86) International application number:
**PCT/JP2008/067559**

(87) International publication number:
**WO 2009/041660 (02.04.2009 Gazette 2009/14)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **28.09.2007 JP 2007255691**
**30.03.2008 JP 2008088955**

(71) Applicant: **Fujifilm Corporation**
**Tokyo 106-8620 (JP)**

(72) Inventors:
• **YAGO, Haruo**
**Ashigarakami-gun**
**Kanagawa 258-8577 (JP)**
• **AONO, Naruhiko**
**Ashigarakami-gun**
**Kanagawa 258-8577 (JP)**
• **HOSOYA, Youichi**
**Ashigarakami-gun**
**Kanagawa 258-8577 (JP)**
• **SATO, Tadanobu**
**Ashigarakami-gun**
**Kanagawa 258-8577 (JP)**

(74) Representative: **HOFFMANN EITLE**
**Patent- und Rechtsanwälte**
**Arabellastrasse 4**
**81925 München (DE)**

(54) **SUBSTRATE FOR SOLAR CELL AND SOLAR CELL**

(57) A substrate for a solar cell, containing a metal substrate and an insulating anodic oxidation film provided on the metal substrate, wherein the thickness To of the anodic oxidation film and the thickness $T_B$ of a barrier layer of the anodic oxidation film are inside a region I surrounded by the point A ($T_O$ = 0.01 μm, $T_B$ = 0.01 μm), the point B (To = 2 μm, $T_B$ = 2 μm), the point C ($T_O$ = 100 μm, $T_B$ = 2 μm) and the point D ($T_O$ = 100 μm, $T_B$ = 0.01 μm) shown in FIG. 1 (provided that the region includes its boundary lines); and a solar cell using the same.

[FIG. 1]

EP 2 197 037 A1

**EP 2 197 037 A1**

**Description**

TECHNICAL FIELD

The present invention relates to a substrate for a solar cell that is flexible, has good voltage resistance characteristics and provides good adhesion properties to an upper layer and allows to form a thin-film solar cell; and also relates to a solar cell using the same.

BACKGROUND ART

Glass substrates are mainly used as thin-film solar cell substrates. However, a glass substrate is fragile and must be treated with considerable care and its lack of flexibility limits the scope of the application. Recently, solar cells have attracted much attention as power supply sources to buildings including homes. It is inevitable to upsize solar cells in order to ensure sufficient electric power to supply, and there has been a demand for a more lightweight substrate that should contribute to production of solar cells with larger areas.
However, a glass substrate would be even more fragile if it is thinned for reduction in weight. Therefore, there has been a demand for development of a less fragile and more flexible substrate material that can be reduced in weight as compared to the glass substrate.

The glass substrate is relatively expensive as compared to a photoelectric conversion layer material for a solar cell, and an inexpensive substrate material is desired in the expectation that such an inexpensive material will help promote the use of solar cells. If a metal is used as such a substrate material, its insulation from a solar cell material arranged thereon is difficult, while a resin substrate cannot withstand a high temperature exceeding 400°C that is necessary to form a solar cell.

Use of a metal substrate also causes a problem in which the thermal expansion coefficient of the metal substrate differs from that of the semiconductor layer of the photoelectric conversion layer, so that the semiconductor layer is susceptible to peeling. To deal with this problem, JP-A-2006-80370 ("JP-A" means unexamined published Japanese patent application) discloses that a glass layer containing 40 to 60 wt% of $SiO_2$, 15 to 30 wt% of $B_2O_3$, 2 to 10 wt% of $Na_2O$, and 8 to 20 wt% of $TiO_2$ is formed on the metal substrate. This glass layer functions as an insulating layer in effect; however, the insulating property is not sufficiently kept by this method only. JP-A-2006-295035 discloses that a first insulating layer is formed on a metal by the sol-gel method, and further a second insulating layer is formed from a different insulating material, thereby insulating the remaining pinhole regions. However, this method also has a problem that a sufficient voltage resistance is not obtained. Further, JP-A-2000-349320 discloses that an anodic oxidation film with a thickness of 0.5 $\mu$m or more is formed as an insulating film. However, there is a problem in which when such an insulating layer is formed only on one side, the shape may be curved due to the difference in thermal expansion coefficient in this method during the process of manufacturing a solar cell.

DISCLOSURE OF INVENTION

The present invention has been made in view of the above circumstances. According to the present invention, there can be provided a substrate for a solar cell being lighter than a glass substrate, highly thermally conductive, less fragile, flexible, and highly insulating; and a solar cell using the same, that is good in voltage resistance characteristics.
According to the present invention, there is provided the following means:

(1) A substrate for a solar cell, comprising:

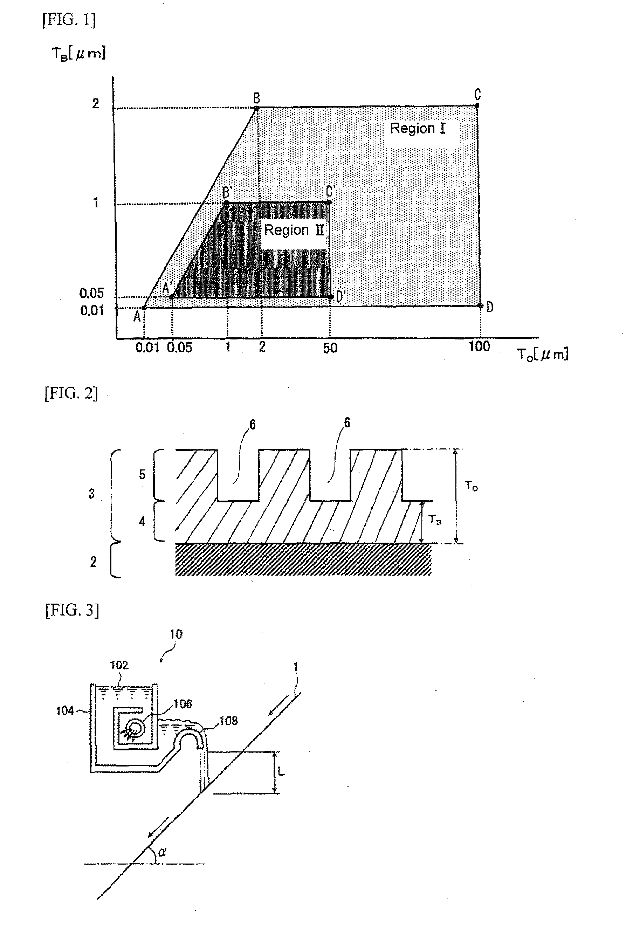

a metal substrate, and
an insulating anodic oxidation film provided on the metal substrate,
wherein the thickness $T_O$ of the anodic oxidation film and the thickness $T_B$ of a barrier layer of the anodic oxidation film are inside of or on the boundary lines of a region I surrounded by the point A ($T_O = 0.01$ $\mu$m, $T_B = 0.01$ $\mu$m), the point B ($T_O = 2$ $\mu$m, $T_B = 2$ $\mu$m), the point C ($T_O = 100$ $\mu$m, $T_B = 2$ $\mu$m) and the point D ($T_O = 100$ $\mu$m, $T_B = 0.01$ $\mu$m) shown in FIG. 1.

(2) The substrate for a solar cell as described in the above item (1), wherein the metal substrate is a substrate containing at least one metal selected from the group consisting of aluminum, zirconium, titanium, magnesium, copper, niobium and tantalum.
(3) The substrate for a solar cell as described in the above item (1) or (2), wherein the metal substrate is a substrate containing a metal selected from the group consisting of aluminum, titanium and copper.
(4) The substrate for a solar cell as described any one of the above items (1) to (3), wherein the thickness $T_O$ of the anodic oxidation film formed on the metal substrate and the thickness $T_B$ of the barrier layer of the anodic oxidation film are inside of on the boundary lines of a region II surrounded by the point A' ($T_O$ = 0.05 $\mu$m, $T_B$ = 0.05 $\mu$m), the point B' ($T_O$ = 1 $\mu$m, $T_B$ = 1 $\mu$m), the point C' ($T_O$ = 50 $\mu$m, $T_B$ = 1 $\mu$m) and the point D' ($T_O$ = 50 $\mu$m, $T_B$ = 0.05 $\mu$m) shown in FIG. 1.

(5) The substrate for a solar cell as described in any one of the above items (1) to (4), wherein the metal substrate is an aluminum substrate.

(6) The substrate for a solar cell as described any one of the above items (1) to (5), wherein the anodic oxidation film is formed on both surfaces of the metal substrate.

(7) The substrate for a solar cell as described any one of the above items (1) to (6), wherein the thickness of the barrier layer is ensured by conducting pore-sealing treatment.

(8) A solar cell, comprising:

the substrate for a solar cell as described in any one of the above items (1) to (7), and
a photoelectric conversion layer provided on the substrate for a solar cell, wherein the photoelectric conversion layer comprises a semiconductor layer comprising at least one Group Ib element, at least one Group IIIb element, and at least one Group VIb element.

(9) The solar cell as described in the above item (8), wherein the photoelectric conversion layer is a semiconductor layer comprising at least one element selected from the group consisting of copper (Cu), silver (Ag), indium (In), gallium (Ga), sulfur (S), selenium (Se), and tellurium (Te).

Other and further features and advantages of the invention will appear more fully from the following description, taking the accompanying drawings into consideration.

BRIEF DESCRIPTION OF DRAWINGS

[Fig. 1] FIG. 1 is a graph showing a region of the total thickness $T_O$ of an anodic oxidation film in a substrate for a solar cell of the invention and the thickness $T_B$ of a barrier layer of the anodic oxidation film.
[Fig. 2] FIG. 2 is a cross sectional view of a metal sheet after the sheet is anodized.
[Fig. 3] Fig. 3 is a schematic cross-sectional view of an apparatus for water washing with a freely-falling curtain-like liquid film.
[Fig. 4] Figs. 4(a) to 4(d) are each a cross-sectional view of a device for illustrating a general method of producing cells of a GIGS thin-film solar cell.
[Fig. 5] Fig. 5 is a diagram showing the relationship between the lattice constant and the band gap of semiconductors composed of Group Ib elements, IIIb elements and VIb elements.

BEST MODE FOR CARRYING OUT INVENTION

Hereinafter, the present invention will be described in detail.
Conventionally, in many substrates for solar cell, glass substrates have been mainly used. In order to produce a light and flexible solar cell; attention has been paid, for the present invention, to metal substrates that are materials having high strength, high toughness, flexibility when made into a thin sheet form, and other features. However, any metal substrate is intolerant of the use thereof for a solar cell since the metal substrate itself is low in insulating property and further does not give a heat resistance sufficient for forming photoelectric conversion regions.
Incidentally, some metal species are well known to form oxide films on their surfaces. As a method for forming the oxide film positively, anodic oxidation treatment is well known. Any oxide film has a low electroconductivity and voltage resistance characteristics, and further has a high melting point; therefore, the film has a sufficient heat resistance even at high temperature, which the film undergoes when the photoelectric conversion regions are formed.
The present invention provides a light and flexible substrate for a solar cell and solar cell by use of a specific metal sheet having a surface coated with an oxide film by anodic oxidation.

[Substrate for Solar Cell]

The metal substrate to be used in the substrate for a solar cell of the present invention may be made of a material from which a metal oxide film can be formed as an insulator on the surface by anodic oxidation. Examples of such a material include aluminum (Al), zirconium (Zr), titanium (Ti), magnesium (Mg), niobium (Nb), tantalum (Ta), and an alloy thereof. In view of cost and the characteristics required for solar cells, aluminum is most preferred. Hereinafter, the present invention will be explained in detail, taking an aluminum substrate as an example.

FIG. 1 is a graph showing a region of the total thickness $T_O$ of an anodic oxidation film in the substrate for a solar cell of the present invention and the thickness $T_B$ of a barrier layer of the anodic oxidation film. In FIG. 1, the horizontal axis represents the total thickness $T_O$ of the anodic oxidation film, and the vertical axis represents the thickness $T_B$ of the barrier layer of the anodic oxidation film. FIG. 2 is a cross-sectional view of a substrate for a solar cell of the invention. As illustrated in FIG. 2, an anodic oxidation film 3 is formed on a surface of a metal sheet 2. The anodic oxidation film 3 has, in the surface, an irregular structure. The film 3 is roughly divided into a barrier layer 4 that is a dense oxide film, and a pore layer 5 wherein pores 6 are formed. In the present invention, the thickness of the barrier layer 4 of the anodic oxidation film is defined as $T_B$, and the total thickness of the anodic oxidation film 3 (the total of the thickness of the barrier layer 4 and that of the pore layer 5) is defined as To.

It is known that the thickness of the barrier layer of the anodic oxidation film and that of the pore layer thereof are each varied in accordance with conditions for the anodic oxidation. The invention has been made based on a finding that by setting the thickness of the barrier layer of the anodic oxidation film and that of the pore layer thereof into a specific region, it is possible to provide a substrate for a solar cell which is excellent in insulating property and flexible, and is not easily cracked.

In order for a substrate for a solar cell to ensure withstand voltage without being affected by the presence of defects such as pinholes, the thickness $T_O$ of the anodic oxidation film and the thickness $T_B$ of the barrier layer of the anodic oxidation film each need to be a thickness equal to or more than a certain value. The large the thickness, the more preferred the voltage resistance characteristics; however, in the anodic oxidation, the upper limit of the film thickness is the thickness of a limit which permits oxygen to be supplied to reaction points by ionic diffusion. Accordingly, the substrate for a solar cell of the invention is characterized by being inside a region I surrounded by a point A ($T_O$ = 0.01 $\mu$m, $T_B$ = 0.01 $\mu$m), a point B ($T_O$ = 2 $\mu$m, $T_B$ = 2 $\mu$m), a point C ($T_O$ = 100 $\mu$m, $T_B$ = 2 $\mu$m) and a point D ($T_O$ = 100 $\mu$m, $T_B$ = 0.01 $\mu$m) shown in FIG. 1 (provided that the region includes its boundary line). However, actually, thermal expansion and shrinkage of aluminum, which is the substrate, need to be restrained by the film thickness. Furthermore, the flexibility of the substrate needs to be ensured. For this purpose, the thickness $T_o$ of the anodic oxidation film and the thickness $T_B$ of the barrier layer of the anodic oxidation film are preferably inside a region II surrounded by a point A' ($T_O$ = 0.05 $\mu$m, $T_B$ = 0.05 $\mu$m), a point B' ($T_O$ = 1 $\mu$m, $T_B$ = 1 $\mu$m), a point C' ($T_O$ = 50 $\mu$m, $T_B$ = 1 $\mu$m) and a point D' ($T_O$ = 50 $\mu$m, $T_B$ = 0.05 $\mu$m) shown in FIG. 1 (provided that the region includes its boundary line).

The observation of the anodic oxidation film, and measurements of the total thickness of the oxide film, the thickness of the barrier layer, and others may each be conducted by any method. A specific example thereof is observation with an electron microscope. The kind of the electron microscope is classified into a transmission electron microscope (abbreviated to a TEM hereinafter) and a scanning electron microscope (abbreviated to an SEM hereinafter). Observation with a TEM is classified into indirect observation using a replica method, direct observation, wherein the film is peeled from the underlay thereof, and direct observation of an ultra thin slice by use of an ultra-microtome. Details thereof are described in "Aluminum Hyomen-gijutsu Binran (Aluminum Surface Technique Handbook)" (published by Nihon Keikinzoku Shuppan, 1980). About the thickness of the barrier layer, a hunter method or some other methods may be used. Details thereof are described in "Aluminum Hyomen-gijutsn Binran (Aluminum Surface Technique Handbook)" (published by Nihon Keikinzoku Shuppan, 1980).

In the substrate for a solar cell of the present invention, it is preferred that pores having a pore diameter of 1 nm to 500 $\mu$m (preferably 10 to 400 nm) are made in the pore layer of the anodic oxidation film. The pores are made preferably at a density of 100 to 10000 pores/$\mu$m$^2$.

The anodic oxidation film is preferably formed on each of both surfaces of the metal substrate. At this time, the anodic oxidation films are preferably formed into thicknesses approximately equal to each other on both the surfaces in order to make thermal strain in the metal substrate including a photoelectric conversion layer equivalent. The film thickness difference between the thickness $T_{O1}$ of the anodic oxidation film formed on one of the surfaces and the thickness $T_{O2}$ of the anodic oxidation film formed on the other surface is preferably from 0.001 to 6 $\mu$m, more preferably from 0.001 to 1 $\mu$m. More preferably, an anodic oxidation film is preferably formed on each end face of the metal. The arithmetic average roughness Ra of the substrate of the present invention is preferably from 0.001 to 200 $\mu$m.

<Aluminum Substrate>

An aluminum substrate may be used in an embodiment of the invention. Such an aluminum substrate is a dimensionally-stable metallic substrate including aluminum as a primary component, such as a substrate made of aluminum or an aluminum alloy. A pure aluminum sheet, an alloy sheet including aluminum as a primary component and a trace amount of a different element(s), or an aluminum- or aluminum alloy-laminated or vapor-deposited plastic film or paper sheet may also be used. Although the composition of the aluminum sheet for use in an embodiment of the invention is not restricted, a pure aluminum sheet is preferably used.

Such a high purity aluminum material preferably has a purity of 99.9% by weight or higher. As the purity of the aluminum material increases, the order of the pores becomes higher after the anodic oxidation, and the size (average pore period) of the region having the order also becomes wider. For electromagnetic device applications, therefore, an aluminum material having a purity as high as possible is preferably used. The purity is preferably 99.99% by weight or higher, more preferably 99.995% by weight or higher, even more preferably 99.999% by weight or higher. Many of commercially available materials with a purity of 99.9% by weight or higher to 99.99% by weight or lower have no blister, although they sometimes have rolling stripes. However, materials with a purity of higher than 99.99% by weight are generally available by special order and often produced with small-scale experimental equipment, when supplied, and they are generally sheet materials having blisters on one level or another.

Aluminum with a purity of 99.99% by weight to 99.999% by weight is generally called high purity aluminum, and aluminum with a purity in a range of 99.999% by weight or higher is called ultrahigh purity aluminum. An aluminum material with a purity of higher than 99.99% by weight is produced by repeated melting and refining in a melting furnace. In the melting process, agitation is performed using gas such as air or inert gas, and therefore, bubbles are trapped. Thereafter, degassing is performed under reduced pressure. In the case of high-purity materials, a very trace amount of impurities must be allowed to float on the surface layer, which requires strong agitation, so that the content of bubbles may be high and that degassing may tend to be insufficient. If such an aluminum material containing bubbles is rolled, a convex portion with a diameter of about 50 $\mu$m to about 2 mm or about 0.1 to about 1 mm and a depth of about 0.1 to about 20 $\mu$m or about 0.3 to about 10 $\mu$m, called "blister" may be formed. Such portions are generally formed at a density of several per $dm^2$ to several hundreds per $dm^2$. Rolling stripes as mentioned above may also be generated by rolling.

Since completely pure aluminum is difficult to produce from the viewpoint of refining technology, the material to be used may contain a trace amount of a different element(s). For example, known materials as described in Aluminum Handbook, 4th ed., Japan Light Metal Association (1990), such as JIS 1050, JIS 1100, JIS 3003, and JIS 3005 materials, and internationally registered alloy 3103A may be used.

An aluminum alloy, a scrap aluminum material, or an aluminum sheet produced with secondary aluminum each having an aluminum (A1) content of 99.4 to 95% by weight and containing at least five elements selected from the following group consisting of iron (Fe), silicon (Si), copper (Cu), magnesium (Mg), manganese (Mn), zinc (Zn), chromium (Cr), and titanium (Ti), in amounts ranging as described below may also be used. In an embodiment of the invention, an aluminum alloy is preferably used for the substrate (support) in the solar cell substrate. The aluminum alloy preferably contains Fe and Si, more preferably further contains Cu, and further preferably further contains Ti.

The aluminum alloy (Al ingot) to be used as a raw material generally contains about 0.04 to 0.2% by weight of Fe. The amount of Fe present in the form of a solid solution in aluminum is small, and most of Fe is present in the form of an intermetallic compound. Fe is effective in increasing the mechanical strength of the aluminum alloy and has a significant effect on the strength of the support. If the Fe content is too low, the mechanical strength of the substrate may be too low, so that the substrate may be susceptible to breaking in the process of placing it in a vapor deposition apparatus and that the substrate may also be susceptible to breaking in the process of performing vapor deposition at high speed on a large number of substrates. If the Fe content is too high, the strength of the substrate may be unnecessarily high, so that the substrate may have a low level of fitness in the process of placing it in a vapor deposition apparatus and may be susceptible to breaking during vapor deposition. For example, if the Fe content is higher than 1.0% by weight, cracking may easily occur during rolling.

The upper limit of the Fe content is preferably 0.29% by weight, so that high mechanical strength can be obtained. In this case, the amount of the Fe-containing intermetallic compound is reduced, so that the number of local depressions formed after the intermetallic compound is removed (or drops off) is small, which leads to a reduction in defects of the crystal consisting the photoelectric conversion layer, favorable in-plane distribution of the electric generation efficiency, and high electric generation efficiency. In view of the Fe content of ingots, the lower limit of the Fe content is preferably and reasonably 0.05% or higher. The lower limit of the Fe content is more preferably 0.20% by weight or higher in terms of maintaining the mechanical strength. Examples of Fe-containing intermetallic compounds include $Al_3Fe$, $Al_6Fe$, Al-Fe-Si compounds, and Al-Fe-Si-Mn compounds.

Si is an inevitable impurity element, and an Al ingot as a raw material generally contains about 0.03 to about 0.1% by weight of Si. Si is often intentionally added in a very trace amount so that different raw materials will not cause variations.

Si is also contained in a relatively large amount in scrap aluminum. Si is present in the form of a solid solution, an intermetallic compound or a simple precipitate in aluminum. When the solar cell substrate is heated in the manufacturing process, simple Si may be precipitated from a solid solution of Si. The inventors have found that Si has an effect on anodizing treatment. In addition, if the Si content is too high, a defective anodic oxidation film may be produced in the anodizing treatment.

In an embodiment of the invention, the Si content is preferably 0.03% by weight or higher and 0.15% by weight or lower. In order to restrain defects in the anodic oxidation film, the content is more preferably 0.04% or more by mass, and 0.1% or less by mass.

Cu is a very important element for improving the heat resistance of aluminium. The Cu content is preferably 0.000% or more by mass, more preferably 0.020% or more by mass, whereby the heat resistance of aluminum is improved and further at the time of the formation of a photoelectric conversion layer, the temperature region therefor can be made wide. On the other hand, if the Cu content is more than 0.15% by mass, the film can cause dielectric breakdown at the time of the anodic oxidation, so that a uniform anodic oxidation film surface may not be obtained.

In an embodiment of the invention, the Cu content is preferably from 0.000 to 0.150% by weight, more preferably from 0.05 to 0.1% by weight, from the above point of view.

Ti has been used as a grain refining agent to refine the crystal structure during casting, and Ti is generally contained in a content of 0.05% by weight or lower. If the Ti content is too high, the film may suffer from dielectric breakdown during anodic oxidation, so that a uniform anodic oxidation film surface cannot be obtained in some cases. In an embodiment of the invention, the Ti content is preferably 0.05% by weight or lower, more preferably 0.03% by weight or lower.

Ti does not have to be contained in the aluminum sheet, and the Ti content may be low. In order to enhance the grain refining effect, however, the Ti content is preferably 0.001% by weight or higher.

Ti is generally added in the form of an intermetallic compound with Al or in the form of $TiB_2$. In order to enhance the grain refining effect, however, Ti is preferably added in the form of an Al-Ti alloy or an Al-B-Ti alloy. When Ti is added in the form of an Al-B-Ti alloy, a very trace amount of boron (B) is also added to the aluminum alloy, which does not reduce the effect of the invention.

When the aluminum sheet containing the different elements in the above-mentioned amount-ranges is used, a uniform anodic oxidation film can be obtained by anodic oxidation treatment that will be detailed later. Thus, when the aluminum sheet is made into an insulating substrate for a solar cell, the insulating property thereof is excellent.

The balance of the aluminum sheet is preferably composed of Al and inevitable impurities. Most of the inevitable impurities are contained in the Al ingot. For example, when contained in an Al ingot with a purity of 99.7%, the inevitable impurities do not reduce the effect of the invention. For example, the inevitable impurities may be contained in amounts as described in L. F. Mondolfo, "Aluminum Alloys: Structure and Properties" (1976).

Examples of inevitable impurities contained in aluminum alloys include Mg, Mn, Zn, and Cr, each of which may be contained in an amount of 0.05% by weight or lower. Any additional element other than these elements may also be contained in an amount known in the art.

The aluminum sheet for use in an embodiment of the invention may be produced by a process including subjecting the above raw material to casting by an ordinary method, subjecting the cast product to an appropriate rolling process and appropriate heat treatment, for example, to produce a 0.1 to 0.7 mm thick product, and optionally performing a flatness correcting process. The thickness may be changed as appropriate.

Examples of methods that may be used to produce the aluminum sheet include a DC casting method, a method of performing DC casting, excluding soaking and/or annealing, and a continuous casting method.

[Manufacture of Solar Cell Substrate]

The solar cell substrate of the invention is obtained by anodizing the above-mentioned aluminum sheet and further subjecting the resultant to a specific pore-sealing treatment. The production process thereof may include various steps besides the essential steps. For example, polishing treatment may be conducted before the anodic oxidation.

(Aluminum Sheet Having Surface formed with Irregularities)

In the production of the substrate for a solar cell of the invention, the following may be used: an aluminum sheet having a surface wherein irregularities are formed; or a sheet obtained by forming irregularities in an aluminum sheet as described above by lamination rolling, transferring or the like in a final rolling step thereof, or some other steps.

(Solar Cell Substrate Production Process)

It is preferred that the aluminum sheet is made into a substrate for a solar cell by causing this sheet to undergo a degreasing treatment step for removing adhering rolling oil, a desmutting treatment step for dissolving smuts on the surface of the aluminum sheet, a mechanical polishing step, and electrolytical polishing step for making the surface of the aluminum sheet smooth, an anodic oxidation treatment step for forming an anodic oxidation film on the surface of the aluminum sheet, and a pore-sealing treatment for sealing micro-pores in the anodic oxidation film.

The production process of the solar cell substrate used in the invention preferably includes a mechanical polishing treatment for making the surface of the aluminum sheet smooth mechanically with a buff or the like.

The production of the substrate for a solar cell of the invention may include, besides the mechanical polishing treatment, a surface treatment step of an aluminum sheet which is combined with an electrolytical polishing treatment of conducting electrolysis by effect of a direct current in an acidic solution. In the production of the substrate for a solar cell of the invention, the polishing and the other individual treatment steps may be in accordance with a continuous method or an intermittent method. It is industrially preferred to use the continuous method.

In an embodiment of the invention, a hydrophilizing treatment may also be performed as needed.

More specifically, the process for producing the substrate for a solar cell of the invention is preferably a process of conducting (a) mechanical polishing treatment, (b) electrolytical polishing treatment, (c) anodic oxidation treatment, and (d) pore-sealing treatment in this order.

Preferred are also a process wherein the treatment (a) is omitted in the above-mentioned process, a process wherein the treatment (b) is omitted in the above process, and a process wherein the treatments (a) and (b) are omitted in the above process.

<Water Washing Treatment>

A water washing treatment is usually performed between respective treatments above so as not to carry over the processing solution to the next step.

The water washing treatment is preferably a treatment where water washing is performed using an apparatus of effecting a water washing treatment with a liquid film in a free-fall curtain shape and then the aluminum sheet is further washed with water by using a spray tube.

FIG. 3 is a schematic cross-sectional view of an apparatus of effecting a water washing treatment with a liquid film in a free-fall curtain shape. As shown in FIG. 3, an apparatus 10 of performing a water washing treatment with a liquid film in a free-fall curtain shape comprises a water storage tank 104 for storing water 102, a water supply tube 106 for supplying water to the water storage tank 104, and a flow controller part 108 for supplying a liquid film in a free-fall curtain shape from the water storage tank 104 to an aluminum sheet 1.

In the apparatus 10, water 102 is supplied from the water supply tube 106 to the water storage tank 104, and the water flow is controlled by the flow controller part 108 when the water 102 overflows from the water storage tank 104, whereby a liquid film in a free-fall curtain shape is supplied to the aluminum sheet 1. In the case of using the apparatus 10, the fluid volume is preferably from 10 to 100 L/min. Also, the distance L between the apparatus 10 and the aluminum 1 in which water 102 exists as a liquid film in a free-fall curtain shape is preferably from 20 to 50 mm. Furthermore, the angle α of the aluminum sheet is preferably from 30° to 80° with respect to the horizontal direction.

When an apparatus shown in FIG. 3 of effecting a water washing treatment with a liquid film in a free-fall curtain shape is used, a water washing treatment can be uniformly applied to the aluminum sheet and therefore, uniformity of the treatment performed before the water washing treatment can be enhanced.

Suitable examples of the apparatus of effecting a water washing treatment with a liquid film in a free-fall curtain shape include an apparatus described in JP-A-2003-96584.

As regards the spray tube for use in the water washing treatment, for example, a spray tube with a plurality of spray tips arranged in the width direction of the aluminum sheet and configured to fan out the injection water may be used. The distance between spray tips is preferably from 20 to 100 mm, and the fluid volume per one spray tip is preferably from 0.5 to 20 L/min. It is preferred to use a plurality of such spray tubes.

<Polishing Process>

Particularly when the plane roughness is desired to be small, at least a mechanical polishing process should be performed among various known metal surface treatment methods for removing relatively large asperities such as "blisters" and "rolling stripes." The mechanical polishing process is preferably followed by an auxiliary process such as a chemical polishing process or an electrochemical polishing process. The polishing method disclosed in JP-A-2007-30146 may be used.

When the surface roughness of the anodic oxidation layer is reduced by the process described below, the mechanical process makes it possible to obtain an aluminum sheet with an arithmetic mean roughness Ra of 0.1 μm or less and a surface glossiness of 60% or higher.

(Arithmetic Mean Roughness Ra)

In general, the arithmetic mean roughness Ra of a metal surface is determined by a process including measuring the roughness of each of portions each having a standard length in the rolling direction and located in the transverse direction perpendicular to the rolling direction, and averaging the measurements. In an embodiment of the invention, the surface roughness is preferably determined by a profile curve method in which the contour of a cross section perpendicular to the surface of interest is determined, and the profile curve is preferably obtained using a contact-probe profilometer for an Ra of 1 μm or more or using an atomic force microscope (AFM) to measure the atomic force for an Ra of less than 1 μm. According to JIS B 601 (1994), a continuous part only with a standard length L is sampled from the roughness curve with respect to each of plural portions (for example, five portions), and the roughness of the sampled part is evaluated with respect to the length to be evaluated. The standard length may be the same as the cut-off value. Within the range of each standard length, various roughness parameters are determined, and the results are averaged with respect to the total number of the standard length portions. The average is used as a measurement. In an embodiment of the invention, the mean surface roughness may be the average of the measurements in the rolling direction and the direction perpendicular to the rolling direction.

(Surface Glossiness)

According JIS Z 8741, the surface of glass having a refractive index of 1.567 over the visible wavelength range (a specular reflectivity of 10% at an incidence angle of 60°) is defined as having a glossiness of 100 (%). However, the surface of glass with a refractive index of 1.567 is susceptible to erosion from moisture. Therefore, a glass surface with a refractive index of about 1.500 (a glossiness of 90%) may be used as a practical standard surface (the absolute value may be corrected every time so that the glossiness of the standard plate can be 90%).

When the glossiness of the surface of common materials is measured, a high glossiness should be measured at a small angle, while a low glossiness should be measured at a large angle. According to JIS, the angle is set to 20°, 45°, 60°, 75°, or 85°. In practice, however, a 60° gloss meter is often used, because of its wide measurement range. This is because the glossiness can be proportional to the angle, and therefore, even if not all the angles are used, the measurement at an angle allows estimation of the glossiness at another angle. According to JIS, the glossiness may be defined by percentage (%) or numerical value.

The glossiness is also called regular reflectance, which may be determined by a process including measuring plural portions in each of the longitudinal direction (parallel to the rolling direction) and the transverse direction (perpendicular to the rolling direction) and averaging the measurements in each direction. The aluminum substrate for use in an embodiment of the invention may have a glossiness of 60% or higher, preferably 80% or higher, in each of the longitudinal and transverse directions.

In an embodiment of the invention, the average glossiness in each of the longitudinal direction and the transverse direction is preferably determined with respect to an area of 50 mm$^2$ or more, more preferably 400 mm$^2$ or more, even more preferably 900 mm$^2$ or more.

The aluminum substrate surface with an arithmetic mean roughness Ra of 0.1 μm or less and a surface glossiness of 60% or higher is considered to be substantially specular and free of visible scratches.

(Mechanical Polishing)

Mechanical polishing is a polishing technique including embedding an abrasive-containing material such as a slurry of a mixture of water and an abrasive in a support material such as a cloth, a paper sheet or a metal or supplying the abrasive-containing material to between the substrate to be polished and the polishing support material; and allowing them to rub against each other so that the substrate is polished with sharp portions of the abrasive. This technique allows mechanical treatment of a large area, delivers high grinding performance and is capable of removing deep scratches. Generally when the substrate is a thin sheet, it should be embedded in a resin material or attached to a metal block so that it can be formed into a shape susceptible to polishing. Particularly for mirror finish, it is called buffing, in which the polishing cloth and the abrasive are characteristics.

(1) Fine Polishing

A waterproof paper sheet or cloth coated with an abrasive such as SiC, diamond or alumina particles is preferably used as a polishing material. Particles with a particle size of about #80 (200 μm) to #4000 (4 μm) may be used. Examples of polishing materials include an abrasive paper sheet composed of waterproof paper and SiC powder embedded therein, a fine grinder composed of a metal and diamond powder embedded therein, and a napped fabric (generally called buff) for use in combination with a slurry or paste including a mixture of an abrasive and water or chemicals.

Abrasives or polishing cloths are preferably used in the order of small number (large particle size) to large number (small particle size) stepwise. Buffing may be performed with a coarse abrasive without performing fine polishing. However, any residual of the course abrasive may cause scratches, and, therefore, it is preferred to perform fine polishing with an abrasive-coated waterproof paper sheet or cloth. The waterproof paper sheet or cloth is preferably changed for every abrasive. Specific examples: Polishing Cloth DP-Net (product name), manufactured by Marumoto Struers K.K., 6 μm to 45 μm in particle size (various types); Polishing Cloth DP-Nap (product name), manufactured by Marumoto Struers K.K., 0.25 μm to 1 μm in particle size (various types); and Waterproof Abrasive Paper #80 to #1500 (product name), manufactured by Marumoto Struers K.K. (various types).

(2) Buffing

Buffing is a technique including providing a buff based on such a material as a cotton cloth, a sisal linen cloth, or wool fibers; rotating, at high speed, the buff with an abrasive bonded to the circumference surface with an adhesive (such as glue) or rotating the buff at high speed, while an abrasive is temporarily held on the surface of the rotating buff; and pressing a workpiece against the rotating surface to polish the material surface so that a uniform surface can be obtained.

a) Polishing Machine

A buffing machine is a polishing machine that performs working with a buff attached to the end of the shaft and rotating at high speed and with an abrasive held on the circumference surface of the buff. Various commercially-available polishing machines may be used, known examples of which include LaboPol-5 (trade name), RotoPol-35 (trade name) and MAPS (trade name) all manufactured by Marumoto Struers K.K.
Polishing may be performed manually or automatically using a tool as needed.

b) Buffs

Examples of buffs include cloth buffs such as sewn buffs, stitched buffs, loose buffs, bias buffs, and sisal buffs; and other buffs such as flap wheels, nonwoven wheels, and wire wheels. These buffs may be used depending on the intended use. Napped cotton buffs are preferred. Specific examples: product names, Polishing Cloth Nos. 101 (wool), 102 (cotton), 103 (synthetic fibers), and 773 (a blend of cotton and synthetic fibers), manufactured by Marumoto Struers K.K.

c) Abrasive

The term "buffing abrasive" refers to an abrasive material that contains relatively fine abrasive particles as a primary component and is prepared by homogeneously mixing the particles with a medium composed of grease and other suitable components. Specific Example: Waterproof Abrasive Paper #80 to #1500 (product name), manufactured by Marumoto Struers K.K. (various types).

c-1) Grease-Based Abrasive

The term "grease-based abrasive" refers to an abrasive produced by kneading fine abrasive particles with grease and solidifying the resulting mixture, which is mainly used for mid-stage polishing or finish polishing in a buffing process. The greases commonly used include stearic acid, paraffin, tallow, and rosin. When the grease-based abrasive is pressed against a buff, the grease is molten by the frictional heat, so that the abrasive particles move to the buff surface along with the grease. When a metal article is pressed against the buff, the grease forms an oil film on the surface of the metal, so that unnecessary biting of the abrasive particles into the metal surface is prevented, which serves to smooth the metal surface. Examples of the grease-based abrasive include emery paste, tripoli, gloss, lime, green rouge, red rouge, white rouge, and grease stick. Particularly preferred are tripoli (primary component, $SiO_2$; Mohs hardness, 7), machiless (phonetic) (primary component, $CaO$; Mohs hardness, 2), green rouge (primary component, $Cr_2O_3$; Mohs hardness, 6), and white rouge (primary component, $Al_2O_3$; Mohs hardness, 9).

c-2) Liquid abrasive

A liquid abrasive is an abrasive produced for use in an automatic buffing machine and produced in the form of a liquid for automatic supply to the buffing machine. A method includes spraying the abrasive from a spray gun and controlling the opening/closing of the nozzle of the spray gun in response to the operation of a timer so that the abrasive can be intermittently sprayed. Known examples include liquid abrasives containing SiC, diamond, or alumina powder. The particle size of relatively coarse abrasives separable by sieving is generally indicated by grit number, and the higher the grit number, the smaller the average particle size.

[Table 1]

| Grit number (Grit #) | 80 | 240 | 400 | 800 | 1000 | 1500 | 2000 | 3000 | 4000 | 8000 |
|---|---|---|---|---|---|---|---|---|---|---|
| Average particle size (μm) | 300 | 80 | 40 | 20 | 16 | 10 | 7.9 | 5 | 4.5-3.1 | 2-1.5 |

Polishing is generally performed using abrasives in the order of coarse size to fine size. Specular gloss starts to appear, when the grit number of the abrasive reaches about #1,000, and a visually specular state is achieved by polishing with an abrasive with a grit number of about #1,500 or more.
Various types of abrasives with average particle sizes of about 0.1 μm to about 104 μm are commercially available, specific examples of which include the products shown below.
Diamond Suspension DP-Spray (product name), manufactured by Marumoto Struers K.K., 0.25 μm to 45 μm in particle size (various types); Alumina Suspension Nos. 100 (1 μm in particle size) to 2000 (0.06 μm in particle size) (product name), manufactured by Meller (various types).

c-3) Polishing Aid

Emery may be bonded to a cloth buff with glue, cement, or the like. Glue forms a viscous liquid when dissolved in hot water. Cement is prepared by mixing a synthetic resin with sodium silicate and used to bond emery to a buff similarly to glue.
Specific examples of methods for removing large and deep asperities (several hundred micrometers to several millimeters) are shown below. The peripheral speed is preferably in the range of 1,800 to 2,400 m/minute.
[Table 2]

| Polishing tool type | Form | Abrasive type | Grit | Polishing material | Ra (μm) after polishing |
|---|---|---|---|---|---|
| Polishing cloth or paper | Sheet | Garnet Alumina Zirconia SiC | #10000-80 | Cloth | 2~0.1 |
| Polishing film | Sheet | Alumina SiC Diamond | #10000~500 | PET | 1.5~0.1 |
| Flap wheel | Wheel | Alumina SiC | #1000~500 | Cloth | 1.5~0.3 |
| Polishing brush | Wheel Roll etc. | Alumina SiC | #3000~100 | Nylon Aramid | 1.5~0.2 |
| PVA grinder | Wheel Roll etc. | Alumina | #10000~3000 | Cloth | 0.1~0.3 |
| Buff | Wheel Rotating sheet | Alumina | #10000~3000 | Napped cloth | 0.1~0.3 |

In particular, an abrasive cloth or paper and a buff are preferred in view of availability and versatility.
All the polishing processes may be performed with buffs. In such a case, it is preferred that rough polishing (with grit of #400 or less) be performed with a sisal linen cloth or a cotton twill, mid-stage polishing (with a grit of #400 to #1000) with a plain weave cotton or rayon cloth, and finish polishing (with a grit of #1000 or more) with a calico, broadcloth, flannel, felt, oxhide, or the like. When the grit number is changed, the cloth should be replaced by a new one, and the polished surface be fully cleaned beforehand.
A detailed description is given in "Jitsumu no tameno Atarashii Kenma Gijutsu (New Practical Technology for Polishing)" published by Ohmsha, Ltd., 1992, 1 st edition, pages 55 to 93.
Electrolytic-abrasive polishing may also be used in place of the mechanical polishing described above.

(Electrolytic-Abrasive Polishing)

Electrolytic-abrasive polishing is a working method including applying a direct current at a current density of preferably 0.05 to 1 A/cm$^2$, more preferably in the order of 0.1 A/cm$^2$, to a workpiece, while abrasively polishing the workpiece under a pressing pressure of 5 to 20 kPa (50 to 200 g/cm$^2$). In general electrolysis at such a current density, a thick passive film is formed on the surface of the workpiece, so that metal is hardly dissolved, and therefore the process does not proceed. Once the passive film is removed by the friction of the abrasive, however, metal is significantly dissolved from the exposed portion, so that the current efficiency rapidly increases to a level of tens to 100%. Thus, the amount of the electro-dissolution is rapidly increased by selective abrasion of micro projections by the abrasive grains, while the amount of processing of the recessed portions is close to zero, so that the surface roughness is rapidly reduced.

Not only general abrasives but also colloidal silica or colloidal alumina may be preferably used. Specifically, high purity colloidal silica PL series manufactured by Fuso Chemical Co., Ltd. may be used, such as PL-1 (primary particle size, 15 nm; secondary particle size, 40 nm), PL-3 (primary particle size, 35 nm; secondary particle size, 70 nm), PL-7 (primary particle size, 70 nm; secondary particle size, 120 nm), and PL-20 (primary particle size, 220 nm; secondary particle size, 370 nm) (all trade names). In addition, PLANERLITE (trade name) series manufactured by Fujimi Incorporated may also preferably be used.

(1) Oscar-Type Polishing Machine

When not only a certain specular rate but also a certain flatness have to be ensured, an Oscar-type polishing machine should preferably be used. An Oscar-type polishing machine, which has been used to polish optical components and so on, has such a structure that the workpiece is rotated in connection with the rotation of the tool surface plate, so that the amount of processing hardly varies with the position and that high form accuracy is easily obtained. On the other hand, electrolytic-abrasive polishing is **characterized in that** it can efficiently reduce the surface roughness. Therefore, a combination of them can achieve high-precision, high-quality mirror finish.

More specifically, electrolytic-abrasive polishing as described in Japanese Patent No. 3044377 or 3082040 may be used.

More specifically, the method described in the text "New Practical Technology for Polishing," published by Ohmsha, Ltd., 1992, 1st edition, pages 55 to 93 may also be used.

(Chemical Polishing and Electrochemical Polishing)

In the process of manufacturing the aluminum substrate for use in an embodiment of the invention, the mechanical polishing is preferably followed by chemical polishing or electrochemical polishing as auxiliary means. As used herein, the term "auxiliary means" means that polishing is performed at a rate of change of 50% or lower of the rate of Ra change obtained by mechanical polishing.

(1) Chemical Polishing Treatment

Chemical polishing treatment may be a process including immersing the aluminum in an aqueous alkaline or acid solution to dissolve its surface. An aqueous alkali solution containing sodium carbonate, sodium silicate, or sodium phosphate alone as a primary component or an aqueous solution of any mixture thereof is preferably used. An aqueous acid solution of sulfuric acid, nitric acid, phosphoric acid, or butyric acid alone or an aqueous solution of any mixture thereof may be used.

After the mechanical polishing treatment, chemical polishing is preferably used as auxiliary means. Some examples are shown in the table below.

[Table 3]

| Kind of solution (Mass %) | Temperature | pH | Time |
|---|---|---|---|
| 0.5 to 2% Sodium carbonate 0.05 to 0.2% Silicate | Room temperature to 50 °C | 9 to 12 | 10 sec. to 30 min. |
| 0.5 to 4% Sodium metasilicate | Room temperature to 70°C | 9 to 12 | 10 sec. to 30 min. |
| 0.6 to 1.8% Sodium carbonate 0.6% Sodium orthophosphate | 50 to 70 °C | 9 to 12 | 10 sec. to 30 min. |
| 0.1 to 0.5% Sodium carbonate 0.6 to 1.2% Sodium silicate | 50 to 70°C | 9 to 12 | 10 sec. to 30 min. |

When the composition is appropriately controlled as shown above, the aluminum substrate can be gradually dissolved so that the mean surface roughness (Ra) can be reduced. Preferred specific examples of the aqueous acid solution are also shown below.

[Table 4]

| Kind of solution (Mass %) | Temperature | pH | Time |
|---|---|---|---|
| 3 to 5% Sulfuric acid | Room temperature | 1 to 0. 3 | 1 to 5 min. |
| 1 to 3 to Nitric acid | Room temperature | 2 to 0. 6 | 1 to 5 min. |
| 4% chromic acid 21% Sulfuric acid | 60°C | -1 | 1 to 5 min. |
| 5% Hydrofluoric acid 2.5% Nitric acid | Room temperature | 0 | 30 sec. to 3 min. |

Also preferred is an aqueous solution of a mixture of sulfuric acid, nitric acid, phosphoric acid, and butyric acid in the composition shown in Table 3 of the text "Aluminum no Hyomen-Shori (Surface Treatment of Aluminum)," published by Uchida Rokakuho Publishing Co., Ltd., 1980, 8th edition, page 36. The Alupol method described in Met. Ind., 78 (1951), 89, in which copper nitrate is added to a liquid mixture of concentrated phosphoric acid and fuming nitric acid, is also a preferred example.

Various methods as described in Table 5.2.17 of "Aluminum Gijutsu Binran (Handbook of Aluminum Technology)" (edited by Japan Light Metals Association and published by Kallos Publishing Co., Ltd., 1996) may also be used. In particular, the phosphoric acid-nitric acid method is preferred.

(2) Electrochemical Polishing Treatment

Electrochemical polishing treatment is a process including dissolving and removing surface asperities from the aluminum sheet in an electrolyte, while generally applying a direct current. Preferred examples of the electrolyte include aqueous acid solutions of hydrogen peroxide, glacial butyric acid, phosphoric acid, sulfuric acid, nitric acid, chromic acid, or sodium dichromate alone, or aqueous acid solutions of any mixture thereof. In addition, ethylene glycol monoethyl ether, ethylene glycol monobutyl ester, or glycerin may also be used as an additive. Such an additive is effective in stabilizing the electrolyte and extending the range where the electrolysis can be properly performed against the concentration change, the change over time, or the degradation during use.

(3) Electrolytic Polishing

After the mechanical polishing treatment, electrolytic polishing is preferably used as auxiliary means. Preferred examples of the electrolysis conditions are shown in the table below.
[Table 5]

| Electrolyte | Temperature | Time, min. | Wave form | Voltage V | Current A/dm$^2$ |
|---|---|---|---|---|---|
| 15 to 25% Aqueous solution of perchloric acid (Specific gravity 1.48) 70 to 80% Glacial butyric acid | 50°C or less | 10 to 20 | Direct current | 50 to 100 | 3 to 5 |
| 40 to 60 vol% Phosphoric acid 5 to 30 vol% Sulfuric acid 15 to 20 vol% Water 0 to 35 vol% Ethylene glycol monoethyl ether | 40 to 70°C | 3 to 10 | Direct current | 10 to 30 | 3 to 60 |

Also preferred are the polishing conditions shown in Table 6 of the text "Surface Treatment of Aluminium," published by Uchida Rokakuho Publishing Co., Ltd., 1980, 8th edition, page 47. Various methods as described in Table 5.2.17 of "Handbook of Aluminum Technology" (edited by Japan Light Metals Association and published by Kallos Publishing Co., Ltd., 1996) may also be used.

In view of availability and safety of the solution to be used, the Battelle method (see British Patent No. 526854 (1940) or British Patent No. 552638 (1943)) or the phosphoric acid bath method (see Japanese Patent No. 128891 (filed in 1935, JP-B-13-004757) ("JP-B" means examined Japanese patent publication)) is preferred.

(Finish Polishing)

The process of manufacturing the aluminum substrate for use in an embodiment of the invention preferably includes performing mechanical polishing, then performing chemical polishing and/or electrolytic polishing as auxiliary means, and then performing CMP (chemical mechanical polishing) or barrier film removing method as auxiliary means.

(1) CMP Method

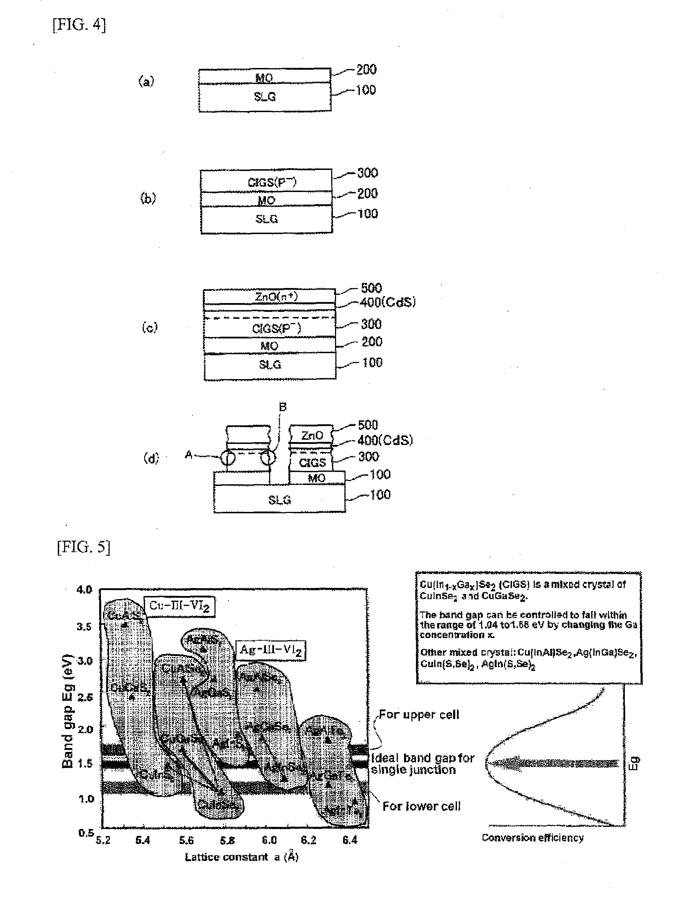

The CMP method is a combination of mechanical polishing and chemical polishing, which is generally used in semiconductor processes. It may also be used to polish the aluminum substrate, as long as the aluminum substrate has been sufficiently polished to have a flat mirror surface. Alumina or silica slurry is generally used in polishing metal such as aluminum. Colloidal alumina or colloidal silica may be used, examples of which include high purity colloidal silica PL series manufactured by Fuso Chemical Co., Ltd. and PLANERLITE series manufactured by Fujimi Incorporated (all trade names). An appropriate amount of $H_2O_2$, $Fe(NO_3)_2$ or $KIO_3$ may also be added as an additive. In order to prevent scratches or burying of the abrasive, the metal surface has to be oxidized by the additive during the polishing. Therefore, an acidic slurry having a controlled pH of 2 to 4 is generally preferred. The abrasive preferably has a primary particle size in the range of 5 nm to 2 $\mu$m, and the slurry concentration is preferably in the range of 2 to 10 vol%. In order to prevent scratches, soft CMP pads are preferably used. Examples include CMP pads XHGM-1158 and XHGM-1167 (all trade names) manufactured by Rodel Nitta.
Also use may be made of methods described in the text: Kazuo Maeda, "Hajimete no Handotai-Seizn-Soti (Introduction of Semiconductor Manufacturing Equipment)," published by Kogyo Chosakai Publishing Inc. March, 1999 (page 171, Fig. 5.44, "Basic Principle of CMP Method and Apparatus Structure" and page 172, Fig. 5.45, Structure of CMP Apparatus).
The CMP method allows high-precision polishing but requires expensive equipment and complicated selection of the abrasive or the additive or complicated setting of polishing conditions. Alternatively, therefore, a barrier film removing method may be used for finish polishing.

(2) Barrier Film Removing Method

After the chemical polishing treatment or the electrolytic polishing treatment, a barrier film removing method may be performed for further smoothing. In this method, a micropore-free barrier-type anodic oxidation film is formed and then removed.
The process of forming a barrier film may generally include performing electrolysis in a nearly-neutral electrolyte with a pH of about 4 to about 8 so that a micropore-free uniform oxide film can be formed. Specific examples of electrolysis conditions are shown below. An aqueous solution of a neutral salt such as borate, adipate, phosphate, citrate, tartrate, oxalate or mixture thereof is preferably used. More specifically, an aqueous boric acid-sodium borate mixture solution, an ammonium tartrate solution, a citric acid solution, a maleic acid solution, a glycolic acid solution, or the like may be used.
More specifically, the electrolysis conditions shown in the table below are preferred. It is known that a micropore-free oxide film is produced by anodic oxidation with such electrolytic solutions. The voltage is preferably in the range of 10 V to 800 V, more preferably 30 V to 500 V. The pH is preferably in the range of 4 to 8, more preferably 5 to 7.
In a preferred range of the electrolysis time, constant current electrolysis is preferably terminated before the voltage is saturated, or constant voltage electrolysis is preferably terminated before there is almost no current flow. The electrolysis time is preferably in the range of 1 to 30 minutes, more preferably 1 to 12 minutes.
The film thickness preferred therein is from 0.1 to 1 $\mu$m, more preferably from 0.2 to 0.6 $\mu$m. It is known that the film thickness becomes larger in proportion to the final electrolytic voltage.
[Table 6]

| Electrolyte | Temperature | Time, sec. | Wave form | Voltage V | Current A / dm$^2$ |
|---|---|---|---|---|---|
| 0.5 mol/L Boric acid | 20 to 9 0°C | 300 to 1200 | Direct current | 0 to 1200 | 25 |
| 0. 5 mol/L Boric acid /0.0005 to 0.05 mol/L Sodium borate | 20 to 90°C | 300 to 1200 | Direct current | 0 to 1200 | 25 |
| 2 mol/L Boric acid /0.005mol/L Ammonium pentaborate | 20 to 90 °C | 300 to 1200 | Direct current | 0 to 1200 | 25 |
| 150g/L Ammonium adipate | 20 to 90°C | 300 to 1200 | Direct current | 0 to 110 | 2.5 |

(continued)

| Electrolyte | Temperature | Time, sec. | Wave form | Voltage V | Current A / dm$^2$ |
|---|---|---|---|---|---|
| 1.4g/L Ammonium dihydrogen phosphate | 20 to 90°C | 300 to 1200 | Direct current | 0 to 110 | 25 |

[Table 7]

| Kind of electrolyte | Concentration | pH | Temperature | Voltage | Thickness of film | Preferred electrolysis time |
|---|---|---|---|---|---|---|
| Ammonium tartrate | 0.27mol/L | 6.7 | 33°C | 100V | 0.15$\mu$m | 1.5 min. to 10 min. |
| Ammonium tartrate | 0.27mol/L | 6.7 | 33°C | 200 V | 0.3$\mu$m | 3 min. to 20 min. |
| Ammonium tartrate | 0.1mol/L | 6.7 | 33°C | 300 V | 0.4$\mu$m | 4 min. to 30 min. |
| Ammonium tartrate | 0.1mol/L | 6.7 | 33°C | 400V | 0.5$\mu$m | 5 min. to 40 min, |
| Ammonium tartrate | 0.1mol/L | 6.7 | 33°C | 500V | 0.6$\mu$m | 6 min. to 60 min. |
| Boric acid Sodium borate | 0.5mol/L-0.05mol/L | 4.5 | 20°C | 100 V | 0.1$\mu$m | 1.5 min. to 10 min. |

The barrier film is generally removed using a mixture of aqueous acidic solutions such as aqueous solutions of phosphoric acid, chromic acid, nitric acid, and sulfuric acid. An aqueous chemical polishing solution or an aqueous solution of chromic acid and phosphoric acid is preferably used.

It is known that the barrier film is generally formed thick at projections and thin at depressions, so that the interface between aluminum and the anodic oxidation film can be made smooth. A smooth surface can be obtained by removing the barrier film. More specifically, the method described in the text "Shin Alumite Riron (New Theories on Anodized Aluminum)" published by Kallos Publishing Co., Ltd., 1997, page 16 may be used.

The barrier film may be formed under these conditions and then dissolved or removed by using an aqueous chromic-phosphoric acid solution or by performing a chemical polishing, so that the mirror finished state can be further improved.

(Method of Removing Barrier Film with Aqueous Chromic-Phosphoric Acid Solution)

An aqueous solution of phosphoric acid and chromic acid is preferably used. More specifically, phosphoric acid, anhydrous chromic acid, and water are preferably used in the composition range to form a mixture.

[Table 8]

| 85% Phosphoric acid | Anhydrous chromic acid | Water | Temperature | Standard immersion time |
|---|---|---|---|---|
| 100 to 140g | 20g to 40g | 1500 g | 50°C | 0.1$\mu$m/min. |

The method described in the literature: "Dai-108-kai Koen-Taikai Yoshi-Shu (Abstract of 108th Lecture Meeting)" 18-B2, pages 76 to 77, published by The Surface Finishing Society of Japan may also be used.

After these polishing processes, the mean surface roughness shown in the table below is obtained in the directions parallel to and perpendicular to the rolling direction (generally indicated as centerline mean roughness Ra).

[Table 9]

| Worming method | Ra [μm] |
|---|---|
| Mechanical polishing | 10 to 0.1 |
| Chemical polishing | 0. 5 to 0.2 |
| Electrolytic polishing | 0. 5 to 0. 1 |
| Electrolytic abrasive polishing | 0. 5 to 0. 01 |
| CMP method | <0. 05 |
| Barrier film removing method | <0. 05 |

<Anodizing Treatment>

In the process of manufacturing the solar cell substrate according to the invention, an anodizing treatment is performed on the aluminum sheet having undergone any of the above mirror finishing processes. An insulating oxide film having a plurality of pores (micropores) is formed on the aluminum substrate by the anodizing treatment.

(Formation of Pits)

A method of anodizing the surface of a member having an aluminum surface includes performing an anodizing treatment to form micropores (hereinafter also referred to as "main anodizing treatment"). Before the main anodizing treatment, pits may be formed, which will serve as start points for the formation of micropores in the main anodizing treatment. When such pits are formed, variations in the arrangement of micropores as described below or variations in the pore size can be easily controlled in the desired range.
Examples of methods for forming pits include, but are not limited to, a self-ordering method utilizing the self-ordering property of an anodic oxidation film, a physical method, a particle beam method, a block copolymer method, and a resist interference exposure method.

(1) Self-Ordering Method

A self-ordering method includes utilizing the ability of an anodic oxidation film to form orderly arranged micropores and eliminating an ordered arrangement-disturbing factor to improve the order. Specifically, the self-ordering method includes providing a high-purity aluminum material, forming an anodic oxidation film thereon at a voltage according to the type of the electrolytic solution for a long time (for example, several hours to more than ten hours) at low speed, and then removing the film.
In this method, the pore size depends on the voltage, and therefore, the desired pore size can be obtained to some extent by controlling the voltage.
Typical known examples of self-ordering methods include methods as described in J. Electrochem. Soc. Vol. 144, No. 5, May 1997, p. L128 (Non-Patent Literature A), Jpn. J. Appl. Phys. Vol. 35 (1996) Pt. 2, No. 1B, L126 (Non-Patent Literature B), Appl. Phys. Lett., Vol. 71, No. 19,10 Nov. 1997, p. 2771 (Non-Patent Literature C).
The methods described in these literatures are technically **characterized in that** the process is performed on a high-purity material at a specific voltage suitable for the electrolytic solution at relatively low temperature for long time. Specifically, all the self-ordering methods are performed on a material with an aluminum purity of 99.99% by weight or higher under the conditions shown below.
0.3 mol/L sulfuric acid, 0°C, 27 V, 450 minutes (Non-Patent Literature A)
0.3 mol/L sulfuric acid, 10°C, 25 V, 750 minutes (Non-Patent Literature A)
0.3 mol/L oxalic acid, 17°C, 40 to 60 V, 600 minutes (Non-Patent Literature B)
0.04 mol/L oxalic acid, 3°C, 80 V, a film thickness of 3 μm (Non-Patent Literature C)
0.3 mol/L phosphoric acid, 0°C, 195 V, 960 minutes (Non-Patent Literature C)

In the methods described in these publications, the process of removing the film includes dissolving the anodic oxidation film in an aqueous chromic acid-phosphoric acid mixture solution at about 50°C for 12 hours or more. The aqueous solution is used without being boiled, because if a boiling aqueous solution is used in the treatment, the start points for ordering will be destroyed and disturbed.

In the self-ordered anodic oxidation film, a portion closer to the aluminum component has higher order. Therefore, ordered pits can be obtained by once removing the film in such a manner that the bottom portion of the anodic oxidation film can be left on the aluminum component and exposed on the surface. In the film removing process, therefore, only the anodic oxidation film (aluminum oxide film) is dissolved without dissolving aluminum.

As a result, the methods described in these publications keep variations in pore size (coefficients of variation) within 3% or less, although different micropore sizes are provided.

For example, the self-ordering anodizing treatment applicable to the production of the aluminum substrate for use in an embodiment of the invention may be performed using a method of energizing the aluminum member as an anode in a solution with an acid concentration of 1 to 10% by weight. Sulfuric acid, phosphoric acid, chromic acid, oxalic acid, sulfamic acid, benzenesulfonic acid, amidosulfonic acid, and so on may be used alone or in combination of two or more thereof in the solution for the anodizing treatment.

The self-ordering anodizing treatment conditions preferably include an electrolyte concentration of 1 to 10% by weight, a solution temperature of 0 to 20°C, a current density of 0.1 to 10 A/dm$^2$, a voltage of 10 to 200 V, and an electrolysis time of 2 to 20 hours, while they vary with the electrolyte used and are not automatically determined. The thickness of the self-ordered anodic oxidation film preferably has a thickness of 10 to 50 $\mu$m.

In an embodiment of the invention, the self-ordering anodizing treatment is preferably performed for 1 to 16 hours, more preferably 2 to 12 hours, even more preferably 2 to 7 hours.

The film removing process is preferably performed for 0.5 to 10 hours, more preferably 2 to 10 hours, even more preferably 4 to 10 hours.

Therefore, if the self-ordering anodizing treatment and the film removing process are performed for a shorter or period of time as compared with known methods, the order of the micropore arrangement may be slightly degraded, and relatively large variations in pore size may be produced, so that the coefficient of variation may be in the range of 5 to 50%.

After the anodic oxidation film is formed by the self-ordering method and then dissolved and removed as described above, the main anodizing treatment described below may be performed again under the same conditions, so that substantially straight micropores can be formed perpendicular to the surface of the film.

(2) Physical Method

An example of the physical method is a method employing press patterning. Specifically, such a method includes pressing, against the aluminum surface, a substrate whose surface has a plurality of projections, so that pits are formed on the aluminum surface. For example, the method described in JP-A-10-121292 may be used.

Another method includes densely arranging polystyrene balls on the aluminum surface, vapor-depositing SiO$_2$ thereon, then removing the polystyrene balls, and etching the substrate through the vapor-deposited SiO$_2$ as a mask to form pits.

(3) Particle Beam Method

A particle beam method includes applying a particle beam to the aluminum surface to form pits. The particle beam method has the advantage that the pit position can be freely controlled.

Examples of the particle beam include a charged particle beam, a focused ion beam (FIB), and an electron beam.

When the particle beam method is used, the order of the pit positions may be disturbed using random numbers for the determination of the pit positions. This can disturb the order of the arrangement of micropores formed by the main anodizing treatment described below, so that the desired variations in pore size can easily be achieved.

The pit may be set at the desired position according to the formula below.

$$\text{The coordinate of the desired position} =$$
$$\text{(the coordinate of the perfectly ordered position)} \pm \text{(the coordinate of the perfectly}$$
$$\text{ordered position)} \times \text{(the coefficient of variation)} \times \text{(random number)}$$

When the sealing treatment is performed by electrodeposition, the coefficient of variation is preferably from 0.05 to 0.5, more preferably from 0.07 to 0.3, even more preferably from 0.1 to 0.2.

When the sealing treatment is performed by a method using colloidal metal particles, the coefficient of variation is determined in accordance with the particle size distribution of the colloidal metal particles used.

For example, the particle beam method described in JP-A-2001-105400 may also be used.

(4) Block Copolymer Method

A block copolymer method includes forming a block copolymer layer on the aluminum surface, forming a sea-island structure in the block copolymer layer by thermal annealing, and removing the island portions to form pits. For example, the block copolymer method described in JP-A-2003-129288 may be used.

(5) Resist Interference Exposure Method

A resist interference exposure method includes providing a resist on the aluminum surface and performing exposure and development on the resist, to form pits passing through the resist to the aluminum surface. For example, the resist interference exposure method described in JP-A-2000-315785 may be used.

Of the above various methods of forming pits, the self-ordering method, the FIB method, and the resist interference exposure method are preferable, because they can uniformly form pits over a large surface area of about 10 cm square or more. In view of manufacturing cost, the self-ordering method is most preferred. The FIB method is also preferred, because the arrangement of micropores can be freely controlled using it.

The pits formed preferably have a depth of about 10 nm or more and a width equal to or less than the desired pore size.

(Anodic Oxidation)

In general, the anodizing treatment conditions preferably include an electrolyte concentration of 0.1 to 1% by material weight of solution, a solution temperature of 5 to 70°C, DC, a voltage of 1 to 200 V, and an electrolysis time of 3 to 500 minutes, while they vary with the electrolyte used and are not automatically determined. In particular, an anodizing method using, as an electrolyte, a solution of sulfuric acid, phosphoric acid, oxalic acid, or mixture thereof is preferred. An anodizing method is more preferably performed in an electrolyte with a sulfuric, phosphoric or oxalic acid concentration of 0.1 to 1% by material weight at a temperature of 10 to 30°C with a direct current and a constant voltage of 30 to 150 V.

The present invention is **characterized in that** a relationship between the thickness $T_O$ of the anodic oxidation film formed by the above-mentioned process and the thickness $T_B$ of the barrier layer of the anodic oxidation film is inside a region I surrounded by a point A ($T_O$ = 0,01 $\mu$m, $T_B$ = 0.01 $\mu$m), a point B ($T_O$ = 2 $\mu$m, $T_B$ = 2 $\mu$m), a point C ($T_O$ = 100 $\mu$m, $T_B$ = 2 $\mu$m) and a point D ($T_O$ = 100 $\mu$m, $T_B$ = 0.01 $\mu$m) shown in FIG. 1 (provided that the region includes its boundary line). The relationship is preferably inside a region II surrounded by a point A' ($T_O$ = 0.05 $\mu$m, $T_B$ = 0.05 $\mu$m), a point B' ($T_O$ = 1 $\mu$m, $T_B$ = 1 $\mu$m), a point C' ($T_O$ = 50 $\mu$m, $T_B$ = 1 $\mu$m) and a point D' ($T_O$ = 50 $\mu$m, $T_B$ = 0.05 $\mu$m) shown in FIG. 1 (provided that the region includes its boundary line). This preferred region is set from a viewpoint that the thermal expansion and shrinkage of aluminum as the substrate needs to be restrained by the film thickness, and further a viewpoint that the flexibility of the substrate should be ensured.

The anodic oxidation film formed by the above method has pores with a pore diameter of 10 nm to 400 nm. In view of smoothness and maintaining insulating properties, the pore diameter is preferably 200 nm or less, more preferably 100 nm or less.

The density of the pores formed on the anodic oxidation film is generally from 100 to 10,000 per $\mu$m$^2$. In view of maintaining insulating properties, the pore density is preferably 5,000 per $\mu$m$^2$ or less, more preferably 1,000 per $\mu$m$^2$ or less.

The surface roughness (Ra) of the anodic oxidation film is from 0.005 $\mu$m to 0.5 $\mu$m. In order to form a photoelectric conversion layer that is an upper layer thereof uniformly, the roughness is preferably 0.3 $\mu$m or less, more preferably 0.1 $\mu$m or less, even more preferably 0.05 $\mu$m or less.

Since the thermal expansion coefficient of aluminum is 22 $\times$ 10$^{-6}$/K, a difference in thermal expansion is generated between the anodic oxidation film, which is alumina, and aluminum. Thus, the anodic oxidation film is more preferably formed on each of both surfaces of the substrate. By making a difference in thickness between the insulating films small, the extents of thermal strains on both the surfaces can be made equal to each other so that the generation of a warp, curling or film-peeling can be prevented. Considering that a photoelectric conversion layer is to be formed on one of the surfaces of the substrate, it is more preferred that the anodic oxidation film (alumina) on the surface on which no photoelectric conversion layer is to be formed is made thicker in order to ensure balance the thermal strains. Considering that the thickness of the photoelectric conversion layer is generally about 3 $\mu$m, it is preferable to make the thickness of the insulating film on the rear surface side larger than that of the insulating film on the side to be formed with photoelectric conversion layer. The difference in film thickness between the anodic oxidation films on both the surfaces is preferably from about 0.001 to 5 $\mu$m, more preferably from 0.01 to 3 $\mu$m, even more preferably from 0.1 to 1 $\mu$m. The method for anodizing both the surfaces may be, for example, a method of anodizing the surfaces one by one, by coating an insulating material on one of the surfaces, and a method of anodizing both the surfaces simultaneously.

<Pore-Sealing Treatment>

In an embodiment of the invention, after the first insulating oxide film (anodic oxidation film) is formed onto the aluminum sheet as described above, pore-sealing treatment of forming a second insulating film in the anodic oxidation film is conducted, thereby sealing micropores generated in the anodic oxidation. According to this pore-sealing treatment, withstand voltage and the insulation resistance are improved so that the substrate for a solar cell becomes excellent in insulating property. By using an aqueous solution containing alkali metal ions as a sealing solution, or by sealing the pores with an alkali-metal-ion-containing compound, the alkali metal ions are incorporated into the pores to be sealed. According to this treatment, at the time of annealing a CIGS layer formed on the insulating layer, the alkali metal ions (preferably, sodium ions) are diffused into the CIGS layer. Thus, the conversion efficiency of the solar cell is improved.

In the present invention, a pore sealing ratio is used as an index for pore sealing by the pore-sealing treatment. Here, the "pore sealing ratio" indicates a ratio in which the surface area of the anodic oxidation film is decreased, and is defined by the following formula.

$$\text{Pore sealing ratio (\%)} = [\{(\text{Surface area of anodic oxidation film before pore-sealing treatment}) - (\text{Surface area of anodic oxidation film after pore-sealing treatment})\}/\text{Surface area of anodic oxidation film before pore-sealing treatment}] \times 100$$

About the anodic oxidation film formed by the above-mentioned method, the pore sealing ratio thereof, which is relative to the pores generated in the anodic oxidation film, is generally from 1% to 90%. From the viewpoint of an improvement in the insulating property, the pore sealing ratio is preferably 20% or more, more preferably 40% or more. From the viewpoint of the adhesive property to any upper layer thereon due to the anchor effect of the pores, the pore sealing ratio is preferably 80% or less, and is preferably 60% or less. This pore sealing ratio, that is, the decrease ratio of the surface area can be controlled by conditions for the treatment. By making, for example, the treating temperature and the treating time long, the pore sealing ratio can be raised.

The surface area of the anodic oxidation film before or after the pore-sealing treatment can be measured using a simple BET-type surface area analyzer (for example, QUANTASORB, trade name, manufactured by Yuasa Ionics Inc.).

For such a pore-sealing treatment, a method known in the prior art may be used. Examples thereof include hydration based pore-sealing such as hydro-thermal sealing treatment, metal salt pore-sealing treatment, organic substance pore-sealing treatment; sealing by introducing an insulator or a compound containing an alkali ion into the pores by PVD or CVD; and sealing by coating an insulator or a compound containing an alkali ion, thereby embedding the pores. Of these examples, preferred are hydro thermal sealing treatment, metal salt pore-sealing treatment, the PVD/CVD treatment, and the coating treatment. Hereinafter, each of the treatments will be explained.

(Hydro thermal Sealing Treatment)

Specific examples of the hydro-thermal-sealing treatment include a method of dipping the aluminum sheet having formed thereon an anodic oxidation film in hot water.

It is preferred that the hot water contains an inorganic alkali metal salt (e.g., an alkali metal phosphate) or an organic alkali metal salt. The temperature of the hot water is preferably 80°C or more, more preferably 95°C or more, and is preferably 100°C or less.

The time for which the aluminum sheet is dipped in hot water is preferably from 10 to 60 minutes.

Other specific examples of the hydro-thermal-sealing treatment include a method of bringing water vapor under applied pressure or normal pressure into continuous or discontinuous contact with the anodic oxidation film (hereinafter, simply referred to as a "water vapor pore-sealing treatment").

The treating temperature for water vapor pore-sealing is preferably from 90 to 110°C, more preferably from 95 to 105°C. If the temperature is lower than 90°C, it is difficult to sufficiently form a surface structure of irregularities having a pitch of 10 to 100 nm. Thus, the adhesive property to any upper layer thereon is not obtained. If the temperature is higher than 110°C, the consumption amount of the vapor becomes large so that economical efficiency lowers. The treatment time for water vapor pore-sealing is preferably from 5 to 60 seconds, more preferably from 10 to 30 seconds.

As for such a water vapor pore-sealing treatment, it is particularly preferred to use the methods described in JP-A-6-1090, JP-A-5-179482 and JP-A-5-202496.

(Metal Salt Pore-Sealing Treatment)

The metal salt pore-sealing treatment is a pore-sealing treatment with an aqueous solution containing a metal salt.

The pore-sealing treatment solution, pore-sealing treatment method, the concentration controlling method and the wastewater treatment, for use in the metal salt pore-sealing treatment, are described in detail below.

Pore-Sealing Treatment Solution

The metal salt for use in the metal salt pore-sealing treatment is suitably a metal fluoride.

From the view point of incorporating alkali metal into pores, specific examples thereof include sodium fluoride, potassium fluoride, calcium fluoride, magnesium fluoride, sodium fluorozirconate, potassium fluorozirconate, sodium fluorotitanate, potassium fluorotitanate, potassium fluorotitanate, fluorozirconic acid, fluorotitanic acid, hexafluorosilicic acid, nickel fluoride, ferric fluoride, fluorophosphoric acid, and ammonium fluorophosphates. These may be used alone or in combination of two or more thereof. From the viewpoint of incorporating alkali ions into the pores, out of these examples, preferred are sodium fluoride, potassium fluoride, calcium fluoride, magnesium fluoride, sodium fluorozirconate, potassium fluorozirconate, sodium fluorotitanate, potassium fluorotitanate, and potassium fluorotitanate. More preferred are sodium fluoride, sodium fluorozirconate, and sodium fluorotitanate.

The concentration of the metal salt in the metal salt-containing aqueous solution is preferably from 0.5 to 4.0 g/L, more preferably from 0.8 to 2.5 g/L, from the standpoint of sufficiently sealing the micropores in the anodic oxidation film.

The metal salt-containing aqueous solution may contain a phosphoric acid salt compound. When the solution contains the phosphoric acid salt compound, the pore-sealing treatment can be conducted at a lower temperature. Thus, costs can be decreased.

Preferable examples of the phosphoric acid salt compound include phosphoric acid salts of metals such as alkali metal or alkaline-earth metal. Specific examples thereof include zinc phosphate, aluminum phosphate, ammonium phosphate, diammonium hydrogen phosphate, ammonium dihydrogen phosphate, monoammonium phosphate, monopotassium phosphate, monosodium phosphate, potassium dihydrogen phosphate, dipotassium hydrogen phosphate, calcium phosphate, ammonium sodium hydrogen phosphate, magnesium hydrogen phosphate, magnesium phosphate, ferrous phosphate, ferric phosphate, sodium dihydrogen phosphate, sodium phosphate, disodium hydrogen phosphate, lead phosphate, diammonium phosphate, calcium dihydrogen phosphate, lithium phosphate, phosphotungstic acid, ammonium phosphotungstate, sodium phosphotungstate, ammonium phosphomolybdate, sodium phosphomolybdate, sodium phosphite, sodium tripolyphosphate, and sodium pyrophosphate. These may be used alone or in combination of two or more thereof.

From the viewpoint of incorporating alkali ions into the pores, out of these examples, preferred are monopotassium phosphate, monosodium phosphate, potassium dihydrogen phosphate, dipotassium hydrogen phosphate, ammonium sodium hydrogen phosphate, sodium dihydrogen phosphate, sodium phosphate, disodium hydrogen phosphate, lithium phosphate, sodium phosphotungstate, ammonium phosphomolybdate, sodium phosphomolybdate, sodium phosphite, sodium tripolyphosphate, and sodium pyrophosphate. More preferred are monosodium phosphate, ammonium sodium hydrogen phosphate, sodium dihydrogen phosphate, sodium phosphate, disodium hydrogen phosphate, sodium phosphotungstate, sodium phosphomolybdate, sodium phosphite, sodium tripolyphosphate, and sodium pyrophosphate.

The concentration of the phosphoric acid salt compound in the metal salt-containing aqueous solution is preferably from 1.0 g/L to less than 10.0 g/L, more preferably from 1.5 to 4 g/L, from the standpoint of enhancing the on-press developability and stain resistance.

In the present invention, the combination of the metal salt and the phosphoric acid salt compound is not particularly limited, but the meal salt-containing aqueous solution preferably contains at least sodium fluorozirconate and contains at least sodium dihydrogen phosphate as the phosphoric acid salt compound.

The concentration of the metal salt is, as described above, preferably from 0.5 to 4.0 g/L, more preferably from 0.8 to 2.5 g/L.

Also, the concentration of the phosphoric acid compound is, as described above, preferably from 1.0 g/L to less than 10.0 g/L, more preferably from 1.5 to 4 g/L.

The temperature of the metal salt-containing aqueous solution is preferably 40°C or more, more preferably 60°C or more. If the temperature is less than 40°C, the pore-sealing property becomes poor, whereas if it exceeds 95°C, liquid evaporation in a large amount is caused and this is not practical. The aqueous solution preferably has a pH of 3 or more, more preferably a pH of 3.2 or more, and preferably has a pH of 5.0 or less, more preferably a pH or 4.5 or less, still more preferably at a pH of 3.8 or less. If the pH is less than 3.0 or exceeds 5.0, the pore-sealing property becomes poor. It is preferred to always control the system during the pore-sealing treatment and adjust the pH by adding phosphoric acid or sodium hydroxide (NaOH).

Pore-Sealing Treatment Method

Suitable examples of the pore-sealing treatment method include preparation of solutions using the above-described pore-sealing treatment solution.

The preparation of solutions may be performed with well water or pure water (ion-exchanged water), but the liquid become clouded during preparation due to reaction of calcium or magnesium in water with fluorine ion or phosphate ion. Therefore, preparation with pure water (ion-exchanged water) is preferred. It is particularly preferable that the metal salt and phosphoric acid compound used for addition are also dissolved in pure water (ion-exchanged water).

In the case where the metal salt (particularly, metal fluoride) and phosphoric acid compound are mixed as powders, in order to achieve good dissociation of fluorine, a metal fluoride is preferably added earlier.

The pore-sealing treatment is preferably performed by a dipping or spraying method. A single method may be used alone once or a plurality of times, or two or more kinds of methods may be used in combination. The spraying method is preferred, because the back surface of the aluminum sheet is not treated and this brings less exhaustion of the solution and decreases the amount of chemicals used.

During operation, sodium, fluorine or phosphoric acid in the solution and the eluted aluminum undergo reaction to produce sodium fluoroaluminate ($Na_3AlF_6$, cryolite) or aluminum phosphate, and the solution becomes clouded. Therefore, the treatment is preferably performed while removing sodium fluoroaluminate ($Na_3AlF_6$, cryolite) or aluminum phosphate by filtration through a filter or by using a settling tank, and it is more preferred to perform the operation while always filtering the solution by using a filter. Since the filter is readily clogged, the operation is particularly preferably performed using two or more filter systems by controlling the pressure and replacing the filter while backwashing the clogged filter to remove residual substances.

In the pore-sealing treatment solution, aluminum dissolves out, but the aluminum ion concentration is preferably controlled to be from 10 to 250 mg/L, more preferably from 100 to 200 mg/L. For controlling the aluminum ion concentration to be from 10 to 250 mg/L, the concentration is adjusted by the renewed amount of the pore-sealing treatment solution (addition of new solution and disposal of solution after treatment).

Also, in the pore-sealing treatment solution, sulfate ion increases due to carry-over of sulfuric acid from the anodization treatment step as the pre-step of the pore-sealing treatment or dissolution of $SO_4$ contained in the anodic oxidation film. The concentration of the sulfate ion is preferably from 10 to 200 mg/L, more preferably from 50 to 150 mg/L. If the concentration is less than 10 mg/L, this requires to increase the renewed amount of the solution and is not profitable, whereas if it exceeds 200 mg/L, the electric conductivity of the solution is affected and the concentration cannot be exactly measured.

(Organic Material Pore-Sealing Treatment)

The organic material pore-sealing treatment is a treatment of sealing pores by the coating or impregnation of an organic material such as fat or synthetic resin.

In the pore-sealing step with an aqueous alkali metal ion solution, it may be incorporated into the pores in the anodic oxidation film. In a method for the introduction thereof into the pores, it is allowable to fill any one of the metal salts described for the pore-sealing treatment into the pores by sputtering or vapor deposition, and subsequently conduct pore-sealing treatment by use of any one of the above-mentioned methods.

(PVD/CVD Treatment)

In a method for the PVD/CVD treatment, a compound containing an alkali metal is introduced into the pores, or a layer of a compound containing an alkali metal is formed onto the insulating layer by sputtering or the like. PVD denotes physical vapor deposition, and CVD denotes chemical vapor deposition. Examples of PVD include sputtering and vapor deposition. Examples of the alkali-metal-containing compound for use in the PVD/CVD treatment include fluorides, sulfides, selenides, chlorides, and silicates of alkali metals. Specific examples thereof include sodium fluoride, potassium fluoride, calcium fluoride, magnesium fluoride, sodium fluorozirconate, potassium fluorozirconate, sodium fluorotitanate, potassium fluorotitanate, sodium sulfide, potassium sulfide, calcium sulfide, magnesium sulfide, sodium selenide, potassium selenide, calcium selenide, sodium chloride, potassium chloride, magnesium chloride, and sodium silicate. These may be used alone or in combination of two or more thereof. From the point of improving the conversion efficiency based on the diffusion of the alkali metal into the photoelectric conversion layer, out of these examples, preferred are sodium fluoride, sodium fluorozirconate, sodium fluorotitanate, sodium sulfide, sodium selenide, sodium chloride, and sodium silicate. More preferred are sodium fluoride, sodium sulfide, sodium selenide, and sodium silicate.

(Coating Treatment)

The method for the coating treatment may be dipping, spin coating, spraying or the like. The material to be coated may be a sol-gel solution containing an alkoxide of a metal such as Si, Ti, Zn or Al, or a solution containing fine particles of an oxide of a metal such as Si, Ti, Zn or Al. From the point of improving the insulating property, it is preferred that after the coating, the resultant is subjected to thermal treatment at 150 to 500°C, thereby forming an oxide layer.

[Solar Cell]

<Formation of Photoelectric Conversion Layer>

The solar cell according to the invention may be produced by forming a photoelectric conversion layer on the solar cell substrate described above.

First, both sides of the aluminum sheet are subjected to the treatments so that a solar cell substrate is produced, and then the solar cell substrate is dried. The drying process prevents contamination of the photoelectric conversion layer production step with water. The photoelectric conversion layer is prevented from being reduced in lifetime due to the contamination with water.

Preferably, a photoelectric conversion layer including a semiconductor composed of at least one Group Ib element, at least one Group IIIb element and at least one Group VIb element (Group I-III-VI semiconductor) is formed on the dried solar cell substrate so that a solar cell is obtained. It may further be bonded to a tempered glass plate with an adhesive such as ethylene vinyl acetate as described in JP-A-2007-123725, so that a solar cell module can be obtained. The photoelectric conversion layer is preferably a semiconductor layer containing at least one element selected from the group consisting of copper (Cu), silver (Ag), gallium (Ga), indium (In), sulfur (S), selenium (Se), and tellurium (Te). The photoelectric conversion layer preferably includes a CIGS semiconductor produced by a selenization technique, a selenization/sulfurization technique, a three-stage technique, or the like. Alternatively, however, the photoelectric conversion layer may include a semiconductor including a Group IVb element such as Si (Group IV semiconductor); a semiconductor composed of a Group IIIb element and a Group Vb element such as GaAs (Group III-V semiconductor); a semiconductor composed of a Group IIb element and a Group VIb element such as CdTe (Group II-VI semiconductor); or combination thereof. In the description, the short periodic table is used to group elements.

In the case of a Si semiconductor, an amorphous silicon thin film layer, a microcrystalline silicon thin film layer, a thin film of Ge-doped amorphous or microcrystalline silicon, or a tandem structure of two or more of these layers may be used to form the photoelectric conversion layer. Plasma CVD or the like may be used to form the film.

An example of the CIGS photoelectric conversion layer is shown below.

A thin-film solar cell having a light absorption layer including a chalcopyrite-structure semiconductor $CuInSe_2$ thin film (CIS thin film) composed of Group Ib, IIIb and VIb elements or $Cu(In,Ga)Se_2$ thin film (CIGS thin film) containing a solid solution of Ga in the above semiconductor, has the advantages of high energy conversion efficiency and less degradation of the efficiency by light irradiation or the like. Figs. 4(a) to 4(d) are each a cross-sectional view of a device for illustrating a general method of producing cells of a CIGS thin-film solar battery cell.

As shown in Fig. 4(a), a Mo (molybdenum) electrode layer 200 to serve as a lower electrode on the plus side is first formed on an anodized aluminum substrate 100. As shown in Fig. 4(b), a light absorption layer 300 including a CIGS thin film and having a controlled composition to show p⁻ type is then formed on the Mo electrode layer 200. As shown in Fig. 4(c), a buffer layer 400 of CdS or the like is then formed on the light absorption layer 300, and a light-transmitting electrode layer 500 to serve as an upper electrode on the minus side, which includes ZnO (zinc oxide) and is doped with an impurity to show n⁺ type, is formed on the buffer layer 400. As shown in Fig. 4(d), a mechanical scribing apparatus is then used to scribe the part from the light-transmitting ZnO electrode layer 500 to the Mo electrode layer 200 at a time, so that the respective cells of a thin-film solar cell are electrically isolated from one another (namely, the cells are each individualized). Materials that may preferably be used to form films in apparatuses for the production of this exemplary embodiment are shown below.

(1) Materials including elements, compounds or alloys each capable of forming a liquid phase at ordinary temperature or upon heating.

(2) Chalcogen Compounds (compounds containing S, Se or Te)

II-VI Compounds: ZnS, ZnSe, ZnTe, CdS, CdSe, CdTe, etc.

Group I-III-$VI_2$ Compounds: $CuInSe_2$, $CuGaSe_2$, $Cu(In,Ga)Se_2$, $CuInS_2$, $CuGaSe_2$, $Cu(In,Ga)(S,Se)_2$, etc.

Group I-$III_3$-$VI_5$ Compounds: $CuIn_3Se_5$, $CuGa_3Se_5$, $Cu(In,Ga)_3Se_5$, etc.

(3) Chalcopyrite-Structure Compounds and Defect Stannite Structure Compounds Group I-III-$VI_2$ Compounds: $CuInSe_2$, $CuGaSe_2$, $Cu(In,Ga)Se_2$, $CuInS_2$, $CuGaSe_2$, $Cu(In,Ga)(S,Se)_2$, etc.

Group I-$III_3$-$VI_5$ Compounds: $CuIn_3Se_5$, $CuGa_3Se_5$, $Cu(InGa)_3Se_5$, etc.

In the above formulae, (In,Ga) and (S,Se) mean $(In_{1-x}Ga_x)$ and $(S_{1-y}Se_y)$, respectively, wherein x and y each represent 0 to 1.

Typical methods for forming CIGS layers are described below, which are not intended to limit the scope of the invention.

1) Multi-Source Simultaneous Vapor Deposition

Typical methods of multi-source simultaneous vapor deposition include the three-stage method developed by NREL (National Renewable Energy Laboratory) in the United State and the simultaneous vapor deposition method by EC group. For example, the three-stage method described in J. R. Tuttle, J. S. Ward, A. Duda, T. A. Berens, M. A. Contreras, K. R. Ramanathan, A. L. Tennant, J. Kaene, E. D. Cole, K. Emery, and R. Noufi: Mat. Res. Soc. Symp. Rroc., Vol. 426 (1996), p. 143. For example, the simultaneous vapor deposition method is described in L. Stolt et al.: Proc. 13th ECPVSEC (1995, Nice), 1451.

A three-stage method may include first simultaneously vapor-depositing In, Ga and Se under high vacuum at a substrate temperature of 300°C, then simultaneously vapor-depositing Cu and Se at a raised temperature of 500 to 560°C and then further simultaneously vapor-depositing In, Ga and Se, so that a graded band gap CIGS film having a graded band gap is obtained. The EC group method is an improvement of the bilayer process developed by The Boeing Company which includes vapor-depositing Cu-excess CIGS at an early stage and vapor-depositing In-excess CIGS at a later stage. The improvement makes the bilayer process applicable to in-line process. The bilayer process is described in W. E. Devaney, W. S. Chen, J. M. Stewart, and R. A. Mickelsen: IEEE Trans. Electron. Devices 37 (1990) 428.

The three-stage method and the EC group simultaneous vapor deposition produce a Cu-excess CIGS film composition in the course of film growth and employ liquid phase sintering of a phase-separated liquid phase $Cu_{2-x}Se$ (x=0-1). Therefore, they have the advantage that a large grain size is produced, so that a CIGS film with favorable crystallinity is formed.

In recent years, various processes for improving the crystallinity of the CIGS film have been studied in addition to these methods. Such processes may also be used.

(a) Method Using Ionized Ga

The method includes allowing vaporized Ga to pass through a grid in which thermionic ions generated from a filament is present, so that Ga collides with the thermion to be ionized. The ionized Ga is accelerated by an extraction voltage and supplied to the substrate. A detailed description is given in H. Miyazaki, T. Miyake, Y. Chiba, A. Yamada, M. Konagai, Phys. Stat. Sol. (a), Vol. 203 (2006) p. 2603.

(b) Method Using Cracked Se

In general, vaporized Se forms a cluster. This method includes thermally decomposing the Se cluster by a high-temperature heater to reduce the molecular size of the Se cluster (Proceedings of the 68th Meeting of the Japan Society of Applied Physics (Hokkaido Institute of Technology, autumn, 2007) 7P-L-6).

(c) Method Using Se Radical

This method is performed using Se radicals generated from a valve tracking system (Proceedings of the 54th Meeting of the Japan Society of Applied Physics (Aoyama Gakuin University, spring, 2007) 29P-ZW-10).

(d) Method Using Photo-Excitation Process

This method includes applying a KrF excimer laser beam (wavelength 248 nm, 100 Hz) or a YAG laser beam (e.g., wavelength 266 nm, 10 Hz) to the substrate surface during three-stage vapor deposition (Proceedings of the 54th Meeting of the Japan Society of Applied Physics (Aoyama Gakuin University, spring, 2007) 29P-ZW-14).

2) Selenization Technique

The selenization technique is also called a two-stage method, which includes first forming a metal precursor of a laminated film such as Cu layer/In layer or (Cu-Ga) layer/In layer by sputtering, vapor deposition, electrodeposition, or the like and heating the metal precursor at about 450 to about 550°C in a selenium vapor or hydrogen selenide, so that a selenium compound such as $Cu(In_{1-x}Ga_x)Se_2$ is produced by a thermal diffusion reaction. This method is called vapor phase selenization. Besides this method, there is a solid-phase selenization technique which includes depositing solid-phase selenium on a metal precursor film and performing selenization by a solid phased diffusion reaction using the solid-phase selenium as a selenium source. At present, only one method is successful for large area mass production, which includes forming a metal precursor film by a sputtering method suitable for large-area production and selenizing it in hydrogen selenide.

However, this method has a problem in which, during selenization, the film expands to about twice its volume, so that internal distortion is generated and that about few $\mu$m voids are formed in the produced film, which have an adverse effect on the adhesion of the film to the substrate or the solar cell characteristics to cause restriction of photoelectric conversion efficiency (B. M. Basol, V. K. Kapur, C. R. Leidholm, R. Roe, A. Halani, and G. Norsworthy: NREL/SNL Photovoltaics Prog. Rev. Proc. 14th Conf.-A Joint Meeting (1996) AIP Conf. Proc. 394).

In order to avoid the abrupt volume expansion during selenization, there are proposed a method of previously mixing a certain amount of selenium into the metal precursor film (T. Nakada, R. Ohnishi, and A. Kunioka: "CuInSe2-Based Solar Cells by Se-Vapor Selenization from Se-Containing Precursors" Solar Energy Materials and Solar Cells 35 (1994) 204-214) and use of a multilayer precursor film including metal thin layers with selenium interposed therebetween (such as a laminate of Cu layer/In layer/Se layer...Cu layer/In layer/Se layer) (T. Nakada, K. Yuda, and A. Kunioka: "Thin Films of CuInSe2 Produced by Thermal Annealing of Multilayers with Ultra-Thin Stacked Elemental Layers" Proc. Of 10th European Photovoltaic Solar Energy Conference (1991) 887-890). The problem of the volume expansion is overcome to a certain extent by these techniques.

However, all the selenization techniques including these techniques have a certain problem, which is that the degree of freedom of film composition control is very low, because a metal laminated film having a specific composition is first used and then subjected to selenization. For example, a current high-efficiency CIGS solar cell uses a graded band gap CIGS thin film in which the Ga concentration is graded in the thickness direction. A method for producing such a thin film by selenization technique includes first depositing a Cu-Ga alloy film, depositing an In film thereon, and selenizing the laminate using spontaneous thermal diffusion so that the Ga concentration can be graded in the thickness direction (K. Kushiya, I. Sugiyama, M. Tachiyuki, T. Kase, Y. Nagoya, O. Yamase, and H. Takeshita: Tech. Digest 9th Photovoltaic Science and Engineering Conf. Miyazaki, 1996 (Intn. PVSEC-9, Tokyo, 1996) p. 149).

3) Sputtering Method

Since sputtering is suitable for large area production, many techniques have been proposed to form CuInSe$_2$ thin films. For example, there are disclosed a method using a CuInSe$_2$ polycrystal as a target and a two-source sputtering method using Cu$_2$Se and In$_2$Se$_3$ as targets and H$_2$Se-Ar mixed gas as sputtering gas (J. H. Ermer, R. B. Love, A. K. Khanna, S. C. Lewis, and F. Cohen: "CdS/CuInSe2 Junctions Fabricated by DC Magnetron Sputtering of Cu2Se and In2Se" Proc. 18th IEEE Photovoltaic Specialists Conf. (1985) 1655-1658). Three-source sputtering methods are also reported in which a Cu target, an In target and a Se or CuSe target are sputtered in Ar gas (T. Nakada, K. Migita, A. Kunioka: "Polycrystalline CuInSe2 Thin Films for Solar Cells by Three-Source Magnetron Sputtering" Jpn. J. Appl. Phys. 32 (1993) L1169-L1172 and T. Nakada, M. Nishioka, and A. Kunioka: "CuInSe2 Films for Solar Cells by Multi-Source Sputtering of Cu, In, and Se-Cu Binary Alloy" Proc. 4th Photovoltaic Science and Engineering Conf. (1989) 371-375).

4) Hybrid Sputtering Method

If the above sputtering methods have the problem of film surface damage by Se negative ions or high-energy Se particles, the problem should be avoided by converting only Se into hot vapor. Nakada et al. fabricated a CIS solar cell with a conversion efficiency of higher than 10% by forming a less-defective CIS thin film by a hybrid sputtering method in which Cu and In metal are sputtered by DC, while only Se is vapor-deposited (T. Nakada, K. Migita, S. Niki, and A. Kunioka: "Microstructural Characterization for Sputter-Deposited CuInSe2 Films and Photovoltaic Devices" Jpn. Appl. Phys. 34 (1995) 4715-4721). Prior to this, Rockett et al. reported a hybrid sputtering method to use Se vapor in place of toxic H$_2$Se gas (A. Rockett, T. C. Lommansson, L. C. Yang, H. Talieh, P. Campos, and J. A. Thornton: Proc. 20th IEEE Photovoltaic Specialists Conf. (1988) 1505). Even more before, a method of sputtering in Se vapor to complement a Se-deficient film with Se (S. Isomura, H. Kaneko, S. Tomioka, I. Nakatani, and K. Masumoto: Jpn. J. Appl. Phys. 19 (Suppl. 19-3) (1980) 23).

5) Mechanochemical Process

This process includes adding raw materials each with the corresponding composition for CIGS to the vessel of a planetary ball mill, mixing the raw materials by mechanical energy to obtain CIGS powder, then applying the powder to the substrate by screen printing, and annealing the print to obtain a CIGS film (T. Wada, Y. Matsuo, S. Nomura, Y. Nakamura, A. Miyamura, Y. Chia, A. Yamada, M. Konagai, Phys. Stat. Sol (a), Vol. 203 (2006) p2593).

6) Other Methods

Other CIGS film forming methods include a screen printing method, a close-spaced sublimation method, an MOCVD method, a spray method, and so on. A thin film of fine particles composed of a Group Ib element, a Group IIIb element, a Group VIb element, and compounds thereof is formed on the substrate by a screen printing method, a spray method or the like and then subjected to heating such as heating in a Group VIb element atmosphere, so that a crystal with the desired composition is obtained. For example, oxide fine particles are applied to form a thin film, and then the thin film is heated in a hydrogen selenide atmosphere. A thin film of PVSEC-17 PL5-3 or an organometallic compound containing a metal-Group VIb element bond is formed on the substrate by spraying or printing and then thermally decomposed, so that the desired inorganic thin film is obtained. In the case of S, for example, the compounds listed below may be used (see for example JP-A-09-74065 and JP-A-09-74213). Metal mercaptide, metal thioate, metal dithioate, metal thiocarbonate, metal dithiocarbonate, metal trithiocarbonate, metal thiocarbamate, or metal dithiocarbamate.

(In-Situ Monitoring)

Transition from a copper-rich composition to a copper-poor composition on a base material is detected by a sensor that detects a physical parameter related to the transition such as radiation. Using a sensor that detects the composition of elements in a vapor-deposited layer, a controller connected to the sensor regulates the flow rate from the vapor source in order to provide a CIGS layer having a homogeneous composition and a uniform thickness along the width of the base material. The thermal conductivity may be obtained from differential temperature measurement between two locations, or the thermal capacity, the resistivity, or the intensity of light reflected or transmitted by the deposited CIGS film may be used. The deposited amounts of the elements of the CIGS film are measured with an XRF (X-ray fluorescent) device, an EDX (energy diffusion X-ray spectroscopy) device, or a surface profilometer, and the total deposited amount of each element (Cu, Ga, In, Se) is measured, so that the thickness and composition of the deposited CIGS layer are determined or the relative amount of Cu to In+Ga is controlled (see Japanese Patent Application National Publication No. 2007-527121).

(Band Gap Value and Control of Distribution Thereof)

Semiconductors of various combinations of Group I-III-VI elements may be used for the light absorption layer of the solar cell. Fig. 5 shows well-known semiconductors. Fig. 5 is a diagram showing the relationship between the lattice constant and the band gap of semiconductors composed of Group Ib elements, IIIb elements and VIb elements. Various band gaps can be obtained by changing the composition ratio. When a photon incident on a semiconductor has energy greater than the band gap, the excess energy with respect to the band gap is lost as heat. A theoretical calculation indicates that a certain combination of a sunlight spectrum and a band gap of 1.4 to 1.5 eV can provide a maximum conversion efficiency. In order to increase the conversion efficiency of a CIGS solar cell, for example, the Ga concentration of $Cu(In_xGa_{1-x})S_2$, the Al concentration of $Cu(In_xAl_x)S_2$ or the S concentration of CuInGa(S,Se) may be increased so that a high-conversion-efficiency band gap can be obtained. The band gap of $Cu(In_xGa_{1-x})S_2$ may be controlled to be in the range of 1 to 1.68 eV.

The band structure may also be biased by changing the composition ratio in the film thickness direction. There may be two graded band gap structures including: a single graded band gap structure in which the band gap increases in the direction from the light incidence window side to the opposite electrode side; and a double graded band gap structure in which the band gap decreases in the direction from the light incidence window to the PN junction and increases beyond the PN junction. For example, such solar cells are disclosed in T. Dullweber, A new approach to high-efficiency solar cells by band gap grading in Cu(In,Ga)Se2 chalcopyrite semiconductors, Solar Energy Materials & Solar Cells, Vol. 67, p. 145-150 (2001). In all the cases, the carrier induced by light is accelerated by the internal electric field generated by the graded band structure so that it can easily arrive at the electrode, which decreases the probability of the coupling to the recombination center and therefore increases the power generation efficiency (reference literature: WO2004/090995).

(Tandem Type)

When different semiconductors with different band gaps are used for different spectrum ranges, the heat loss due to the difference between the photon energy and the band gap can be reduced so that the power generation efficiency can be increased. Such a structure using a laminate of different photoelectric conversion layers is called tandem type. In the case of a two-layer tandem, for example, a combination of 1.1 eV and 1.7 eV may be used to improve the power generation efficiency.

(Structures Other Than Photoelectric Conversion Layer)

Group II-VI compounds such as CdS, ZnO, ZnS, and Zn(O,S,OH) may be used as n-type semiconductors to form a junction with the Group I-III-VI compound semiconductor. These compounds are preferred, because they can form a junction interface free from recombination between the photoelectric conversion layer and the carrier. See for example JP-A-2002-343987.

Metal such as molybdenum, chromium, or tungsten may be used to form the back surface electrode. These metal materials are preferred, because they are not susceptible to being mixed with other layers even in heat treatment. When a photovoltaic layer including a Group I-III-VI compound semiconductor layer (light absorption layer) is used, a molybdenum layer is preferably used. On the back surface electrode side, a recombination center is present at the interface between the light absorption layer CIGS and the back surface electrode. Therefore, if the contact area between the back surface electrode and the light absorption layer is unnecessarily excessive for electrical conduction, the power generation efficiency may be reduced. In order to reduce the contact area, for example, the electrode layer may have such a structure that an insulating material and a metal material are arranged in stripes. See for example JP-A-09-219530.

About a conventional solar cell using a glass substrate, it is shown that an alkali metal element (Na element) contained in sodium lime glass, which serves as the substrate, diffuses into its CIGS film so that grains grow, and it is reported that the solar cell using such the CIGS film, wherein the alkali metal element is diffused, showed higher energy conversion efficiency (M. Bodegard et al., "THE INFLUENCE OF SODIUM ON THE GRAIN STRUCTURE OF CuInSe$_2$ FILMS FOR PHOTOVOLTAIC APPLICATIONS", 12th European Photovoltaic Solar Energy Conference). In the same manner as the above, it is also preferred to diffuse an alkali metal into CIGS film in an embodiment of the present invention. The alkali metal element may be diffused by a method of forming an alkali layer containing the alkali metal element onto a Mo electrode (rear surface electrode) layer by vapor deposition or sputtering, as described in JP-A-8-222750; a method of forming an alkali layer made of Na$_2$S or the like on a Mo electrode layer by immersing, as described in a pamphlet of WO 03/069684; or a method of forming a precursor containing In, Cu and Ga metal elements on a Mo electrode layer, and then causing an aqueous solution containing sodium molybdate to adhere onto this precursor, as disclosed in JP-A-2006-210424. An appropriate method may be selected from these methods in accordance with the method of forming CIGS film. The diffusing method is not limited to these methods, and the clement may be diffused by a different method.

(Application of Adhesive Layer)

A buffer layer of Ti may be used at the interface between Mo or W as a back surface electrode and CuInSe$_2$, Ti diffuses and reacts with Mo and Cu as a semiconductor forming element in heat treatment during formation of semiconductor, so that a chemically adhesive mechanism can be established and a high-quality ternary semiconductor thin film can be obtained with high reproducibility (see JP-A-5-315633).

A buffer layer of Ta, Cr, Nb, Ti, or titanium nitride having a thermal expansion coefficient halfway between Al and Mo may be interposed between the Mo electrode layer and an anodized aluminum substrate, so that electrode peeling attributable to the difference in expansion coefficient between Mo and Al during high temperature process can be prevented (see JP-A-06-252433 and Japanese Patent Application National Publication No. 09-503346).

In the selenization method, between a Mo electrode and a precursor thin film, a thin film for buffering is formed which is made of a metal element in Group Ib and a metal element in Group IIIb and is lower in Ga concentration than the precursor thin film, and further the buffering thin film and the precursor thin film are subjected to thermal treatment in a Se atmosphere, whereby an optical absorption layer of a CIGS type can be formed (see JP-A-2003-188396).

(Back Surface Electrode Junction Interface Reduction)

A comb-like or grid-type back surface electrode is preferably used. A metal electrode of Mo, W, Ti, Ta, Au, Pt, Ni, Cr, Ag, or Al is preferably used (see JP-A-09-172193 and JP-A-09-219530).

(Adjustment of Film Stress of Back Surface Electrode)

In a sputtering method, the substrate temperature, the film forming rate, sputtering gas pressure, etc. have an effect on film formability. The relationship between the metal sputtering gas pressure and the film stress and electrical resistance was examined into details by John A. Thornton and David W. Hoffman (see J. Vac. Sci. Technol., Vol. 14, No. 1, Jan./Feb. 1977). When a Mo film is so formed that compressive stress is from 0 to 0.4 GPa, the generation of MaSe$_x$ responsible for peeling of a CIS thin film and an increase in contact resistance can be reduced (see JP-A-10-135501 and JP-A-2000-12883).

(Addition of Na)

An oxide thin film Cu-In-O:Na$_2$O$_2$ composed of Group Ib elements and IIIa elements and doped with a Group Ia oxide Na$_2$O$_2$ that serves as a dopant is deposited on a precursor layer formed by a selenization method, and then subjected to heat treatment in an atmosphere containing a Group VIa element (an Ar-hydrogen gas mixture containing Hose) (see JP-A-09-55378).

An alkaline metal such as Na is added to the first layer in a two-stage growth method (see JP-A-10-74966). The ratio of the Group Ib element to the Group III element included in the light absorption layer doped with the Group IIa element is from 0.22 or higher to 0.75 or lower in the composition used (see JP-A-10-74967).

(Back Surface Electrode Suitable for Na Addition)

A preferred structure includes at least two conductive layers and a Group Ia element-containing layer provided between the conductive layers, so that segregation of Na at the surface of the anodized aluminum substrate can be prevented, although the in-plane uniformity is not good. The thermal expansion coefficient of Mo in general use is small as compared to those of the CIGS film and the substrate, and therefore peeling may occur during the manufacturing process that includes a high temperature procedure such as a CIGS film forming step. As means for solving the problem of the peeling from the substrate, a method of layering Mo films was reported by John H. Schofield et al. (Thin Solid Films, 260, (1995), pp. 26-31). A multi-layer film is less likely to be pelled off. Examples of the Group Ia element-containing layer include Na$_2$S, Na$_2$Se, NaCl, NaF, sodium molybdate, and aluminum oxide layers.

When the crystal grain size of the lowermost layer in the conductive layer is greater than the crystal grain size of the uppermost layer, the adhesion to the substrate is improved, and the layer is less likely to be peeled off from the substrate even after the high temperature process such as the step of forming films such as a compound semiconductor layer for a solar cell. On the other hand, the layer having a grain size smaller than this has better conductivity. When the lowermost layer of the conductive layer has a smaller density than that of the uppermost layer, the adhesion to the substrate is improved, and the layer is less likely to be peeled off from the substrate even after the high temperature process such as the step of forming films such as a compound semiconductor layer for a solar cell. On the other hand, the layer having a greater density than the above in the conductive layer has improved conductivity (see JP-A-2004-79858).

(Alkaline Barrier)

A precursor containing In, Cu, and Ga metal elements is formed on a back surface electrode layer, and then the substrate coated with a sodium molybdate-containing aqueous solution is subjected to heat treatment in a H$_2$Se gas atmosphere. A two-layer alkaline barrier layer is formed, which includes a silica layer and a first layer of a multi-layer metal back surface electrode layer (having its crystal grain size adjusted) (see JP-A-2006-210424 and JP-A-2006-165386).

A discussion about the effect of forming the alkaline barrier layer upon a solar cell characteristics reached a conclusion that the alkaline barrier layer is necessary (see David F. Dawson-Elli,el al., "Substrate Influences On CIS Device Performance," Proc.1st World Conference of Photovoltaic Energy Conversion (1995)152-155, C.Jensen, "The Study of Base Electrode/Substrate Interactions By Use of Air Anneal Imaging," Proc.13th European photovoltaic Solar Energy Conference (1995), JP-A-11-312817 and JP-A-2006-165386).

There is an example using a manufacturing process including intentionally forming an alkaline barrier layer (TiN, Al$_2$O$_3$, SiO$_2$, Si$_3$N$_4$, ZrO$_2$, TiO$_2$ or the like) capable of completely preventing diffusion of an alkaline component from a blue plate glass substrate, forming a metal back surface electrode thereon, and further forming another layer containing a necessary amount of Na to produce a solar cell. In this example, such an alkaline barrier layer is intentionally produced, the metal back surface electrode is formed thereon, and then a layer containing an necessary amount of Na, K, Li, or the like is separately produced (by adding a compound such as Na$_2$S or Na$_2$Se by doping) (see V.Probst,el al., "Large Area CIS Formation By Rapid Thermal Processing Of Stacked Elemental Layers," Proc. 17th European Photovoltaic Solar Energy Conference (2002) 1005-1010, V. Probst, el al., "Advanced Stacked a CIS Formation By Rapid Thermal Processing Of Stacked Elemental Layer Process For Cu(InGa)Se2 Thin Film Photovoltaic Devices," Mat. Res. Soc. Symp. Proc., Vol. 426 (1996) 165-176, J. Holz, et al.,: Proc. 12th European Photovoltaic Solar Energy Conference (1994) 1592-1595, JP-A-08-222750, JP-A-2007-266626, and JP-A-2003-318424).

In the above-described studies, an independent alkaline barrier layer including oxide, nitride or the like is formed on a blue plate glass substrate, and diffusion of the alkaline component from the blue plate glass substrate is related to the film forming methods (R. J. Araujo, el al., "Sodium Redistribution Between Oxide Phases," Journal of Non-Crystalline Solids, 197 (1996) 154-163). On the other hand, it was reported that a metal back surface electrode layer alone without an alkaline barrier layer can only partly block diffusion of an alkaline component (J. Holz, et al.: Proc. 12th European Photovoltaic Solar Energy Conference (1994) 1592-1595).

(Improvement of Conversion Efficiency by Increasing Back Surface Reflection Light)

A composite back surface contact layer is formed between the substrate and the light absorption layer. At the time, the layer includes a back surface reflector layer that raises the reflectivity, a contact layer that secures an appropriate electrical characteristic for the back surface contact, and/or a conductance layer that secures low sheet resistance with respect to in-plane current (see Japanese Patent Application National Publication No. 2007-528600).

(Scribing)

In a solar cell actually used, a plurality of cells are packaged and processed as a module (panel). A plurality of unit cells are connected in series by each scribing step. In a thin-film solar cell, the number of series stages (the number of unit cells) may be changed so that the cell voltage can be changed and designed as desired. This is one of the advantages of the thin-film solar cell. When a solar cell having such an integrated structure is formed, the process includes first scribing to separate a Mo back surface electrode, second scribing to separate a light absorption layer in order to electrically connect a transparent electrode and the back surface electrode of an adjacent cell, and third scribing to separate the transparent electrode. A transparent electrode is provided on a groove formed after the second scribing so that electrical conduction is established according to conventional techniques. Alternatively, the light absorption layer may be modified by light irradiation so that conduction can be established, which can reduce the number of the scribing steps to two. The light absorption layer at the conducting portion has a greater Cu/In ratio. In other words, the layer has a p+ type or conductive characteristic with a small amount of In (see JP-A-2007-109842, JP-A-2007-123532, JP-A-2007-201304, JP-A-2007-317858, JP-A-2007-317868, JP-A-2007-317879, and JP-A-2007-317885). Disclosed prior art related to scribing includes a technique of scraping a light absorption layer and a buffer layer by moving and pressing a tip-tapered metal needle under predetermined pressure (see JP-A-2004-115356), and a technique including applying, to a light absorption layer, a laser beam emitted from a Nd:YAG crystal excited by a continuous discharge lamp such as an arc lamp (Nd:YAG laser), so that the light absorption layer is removed and divided (see JP-A-11-312815).
In order to prevent defects from being formed in a light absorption layer by scribing stress, an underlying electrode layer (Mo), a p-type compound semiconductor thin film (CIGS thin film) having a chalcopyrite structure that serves as a light absorption layer, and an n-type light transmitting electrode layer (ZnO) are patterned by etching by photolithography, and the CIGS thin-film is subjected to two-stage etching including dry etching and wet etching, so that high precision patterning can be achieved with no damages or defects generated in the compound semiconductor crystal and with no residual liquid (see JP-A-2007-123721).
Known materials such as ITO, ZnO:Ga, ZnO:Al, ZnO:B, and $SnO_2$ may be used to form transparent electrodes. These materials are preferred, because they are highly light-transmitting and have low resistance and high carrier mobility. See for example JP-A-11-284211.
Examples of the layer structure include a superstrate type and a substrate type. When a photovoltaic layer including a Group I-III-VI compound semiconductor layer (light absorption layer) is used, a substrate type structure is preferably used, because of its high conventions efficiency.

(Buffer Layer, Window Layer and Transparent Electrode)

Examples of the buffer layer may include CdS, ZnS, ZnS (O, OH), and ZnMgO. Examples of the window layer may include various transparent conductive materials such as ZnO and ITO. If for example the Ga concentration of CIGS is raised to increase the band gap of the light absorption layer, the conduction band becomes too large as compared to the conduction band of ZnO, and therefore the use of ZnMgO having large energy in the conduction band is preferable for the buffer layer. The buffer layer in the band structure including the CIGS/the buffer layer/the window layer (ZnO) can be prevented from having a spike shape (upward protrusion) and causing a drop in saturation current or having a cliff shape (recess) and causing a drop in release current to lower FF, so that the power generation efficiency can be increased when the band gap is large.
The substrate for a solar cell of the invention is a substrate wherein a metal substrate having an anodic oxidation film is used. The substrate is excellent in insulating property, is lighter in weight and higher in thermal conductivity and is less easily cracked than glass substrates, and has flexibility. The solar cell of the invention, wherein this substrate is used, is light and flexible, is capable of being produced at low costs, and has suitable voltage resistance characteristics.

EXAMPLES

The present invention will be described in more detail based on the following examples, but the invention is not intended to be limited thereby.

Example 1

1. Polishing of Aluminum Sheet

The aluminum material used was a custom made 5N aluminum sheet with an area of 5 cm x 5 cm manufactured by Nippon Light Metal Co., Ltd. (analytical result (wt%): Al, 99.999% or higher; Cu, lower than 0.0002%; Si, lower than 0.0002%; Fe, lower than 0.0002%). The aluminum material was polished using the mechanical polishing method described below.

A1) Mechanical polishing

A polishing machine LaboPol-5 (trade name) manufactured by Marumoto Struers K.K. was used.
A 5 cm square sample was bonded to a mirror finished metal block with a double-sided adhesive tape (removable tape 9455 manufactured by Sumitomo 3M Limited). The sample was polished with abrasive paper sheets in the order of increasing grit number (#80-#240-#500-#1,000-#1,200-#1,500) until no surface asperities were visually observed.
The abrasive paper sheets used were Waterproof Abrasive Paper (trade name) manufactured by Marumoto Struers K.K.

A2) Mechanical polishing

A polishing machine LaboPol-5 (trade name) manufactured by Marumoto Struers K.K. was used.
A 5 cm square sample was bonded to a mirror finished metal block with a double-sided adhesive tape (removable tape 9455 manufactured by Sumitomo 3M Limited). Polishing was sequentially performed using abrasives and polishing clothes, which were changed as shown below, until no surface asperities were visually observed.
Abrasives: Diamond Abrasive DP-Spray P series (trade name) manufactured by Marumoto Struers K.K. in the order of SPRIR (particle size, 45 $\mu$m), SPRAM (particle size, 25 $\mu$m), SPRUF (particle size, 15 $\mu$m), SPRAC (particle size, 9 $\mu$m), SPRIX (particle size, 6 $\mu$m), SPRRET (particle size, 3 $\mu$m), SPRON (particle size, 1 $\mu$m), and SPRYT (particle size, 0.25 $\mu$m).
Buffing was performed using the above diamond slurries in the order of coarse to fine, so that a mirror-finished state was obtained. The buff was changed when the abrasive was changed.
The buffs used were polishing cloths No. 773 (particle size, 10 $\mu$m or more) and No. 751 (particle size, less than 10 $\mu$m) manufactured by Marumoto Struers K.K.
In all the castes, the residual blister density was 0 per dm$^2$, Ra was 0.1 $\mu$m, and the average glossiness was 75%.

2. Formation of substrate for solar cell

Substrates were each formed as follows: an aluminum sheet of 0.30 mm thickness was subjected to a graining treatment on the surface with using a nylon brush and an aqueous suspension of pumice stone having a 400 mesh, and then the sheet was sufficiently washed with water. The sheet was immersed in 10% sodium hydroxide at 70°C for 60 seconds so as to be etched, and then the sheet was washed with flowing water. The sheet was then neutralized and washed with 20% HNO$_3$, and washed with water. An alternating waveform current of a sine wave was used to subject this substrate to electrolytical roughening treatment at an anode-time electricity quantity of 160 C/dm$^2$ in a 1% nitric acid aqueous solution under a condition of $V_A$ = 12.7 V. The surface roughness thereof was measured. As a result, the roughness was 0.6 $\mu$m (Ra notation). Subsequently, the sheet was immersed in a 30% H$_2$SO$_4$ aqueous solution so as to be de-smutted at 55°C for 2 minutes. Thereafter, a cathode was arranged on the grained surface, and the resultant was subjected to anodic oxidation treatment. About anodic oxidation treatment conditions, the electrolyte, the concentration of the electrolyte, the temperature, the current density, the voltage and the oxidizing time were varied. The film thicknesses of the anodic oxidation films, and the thicknesses of the barrier layers are shown in Table 10 descried below.

<Method for Evaluating Voltage Resistance Characteristics>

Next, an aluminum electrode (thickness: 400 nm), 3 cm $\times$ 3 cm in size, was formed on the anodic oxidation film on one of the surfaces of each of the anodic oxide aluminum substrates (substrate for a solar cells) obtained above by vapor deposition. Furthermore, the anodic oxide aluminum on the other surface was shaved off.
About each of the anodic oxide aluminum substrates obtained as described above, a voltage was applied to the aluminum electrode formed on one of the anodic oxide aluminum films and the region where the anodic oxide aluminum was partially shaved off on the other side across the electrode and the region. The withstand voltage of the anodic oxidation film was measured. As the withstand voltage, the following was used: the voltage applied when electric insulation was broken between the electrodes and the metal substrate. The insulation resistance was also measured. The results are shown in Table 10 described below.

[Table 10]

Table 10

| Sample name | Film thickness ($\mu$m) | Thickness of barrier layer ($\mu$m) | Withstand voltage (V) | Insulation resistance (M$\Omega$cm$^2$) | Flexibility[*] | Remarks |
|---|---|---|---|---|---|---|
| Sample 1-1 | 0.005 | 0.005 | 100 | 0.01 | Excellent | Comparative example |
| Sample 1-2 | 1.2 | 0.005 | 120 | 0.01 | Excellent | Comparative example |
| Sample 1-3 | 2.1 | 0.005 | 130 | 0.02 | Excellent | Comparative example |
| Sample 1-4 | 2.5 | 2.2 | 1200 | 9.1 | Poor | Comparative example |
| Sample 1-5 | 105 | 1.1 | 1050 | 8.8 | Poor | Comparative example |
| Sample 1-6 | 1.2 | 0.010 | 300 | 1.0 | Excellent | This invention |
| Sample 1-7 | 1.2 | 0.100 | 500 | 4.1 | Excellent | This invention |
| Sample 1-8 | 1.2 | 0.300 | 600 | 4.5 | Excellent | This invention |
| Sample 1-9 | 2.3 | 0.350 | 650 | 5.1 | Excellent | This invention |
| Sample 1-10 | 5.1 | 0.400 | 730 | 5.9 | Excellent | This invention |
| Sample 1-11 | 10.5 | 0.450 | 800 | 7.1 | Excellent | This invention |
| Sample 1-12 | 2.5 | 1.5 | 1010 | 8.1 | Good | This invention |
| Sample 1-13 | 80 | 1.8 | 1150 | 8.9 | Good | This invention |
| Sample 1-14 | 90 | 0.450 | 1090 | 8.2 | Good | This invention |
| [*] Notation of Flexibility in the Table<br>Excellent; No crack is generated due to flexing<br>Good; No crack is generated with slight amount of flexing<br>Poor; Crack is generated due to flexing | | | | | | |

As is evident from the results shown in Table 10, the following was found: in the solar cell substrates according to the invention, in each of which the thickness To of the anodic oxidation film and the thickness $T_B$ of the barrier layer of the anodic oxidation film were inside the region I shown in FIG. 1, both of the voltage resistance characteristics and the insulating property were very good and flexibility was able to be kept. The following was also found: in particular, in the solar cell substrate of the invention wherein the thickness To of the anodic oxidation film and the thickness $T_B$ of the barrier layer of the anodic oxidation film were inside the region II shown in FIG. 1, excellent voltage resistance characteristics, excellent insulating property and excellent flexibility were compatibly obtained with a good balance.

Example 2

The sample 1-8 of Example 1 according to the invention was used as a substrate. After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 $\mu$m. A CuInGaSe$_2$ thin film was deposited on the Mo film in a vacuum chamber. In the deposition of the CuInGaSe$_2$ thin film, a Cu (the primary component of CuInGaSe$_2$) evaporation source, an In evaporation source, a Ga evaporation source, and a Se evaporation source were provided in the vacuum chamber 1, and the Cu, In, Ga, Se evaporation source crucibles were heated at the degree of vacuum of about $10^{-7}$ Torr so that each element was evaporated. In this process, the crucible temperature was controlled as needed. The CuInGaSe$_2$ thin film was formed to have a two-layer structure as described below. The first layer of the two-layer structure was so formed that Cu was in excess of the total of In and Ga in the atomic composition, and the second layer of the two-layer structure was subsequently so formed that the total of In and Ga was in excess of Cu in the atomic composition. The substrate temperature was kept constant at 550°C. The first layer was vapor-deposited with a thickness of about 2 $\mu$m. At this time, the atomic composition ratio Cu/(In+Ga) was about from 1.0 to 1.2. The second layer was then vapor-deposited with a thickness of about 1 $\mu$m so that the final atomic composition ratio Cu/(In+Ga) could be 0.8 to 0.9.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by a MOCVD method.

Next, an Al-added ZnO film as a transparent conductive film was deposited into a thickness of about 200 nm thereon by a MOCVD method.

Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm$^2$. As a result, a conversion efficiency of 10.0% was obtained. The result indicates that even when the anodized aluminum substrate according to the present invention is used to form a solar cell, the resulting solar cell shows sufficient photoelectric conversion efficiency.

Example 3

The sample 1-8 of Example 1 according to the invention was used as a substrate. After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 $\mu$m.

A CuInGaSe$_2$ thin film was deposited on the Mo film in a vacuum chamber. Initially, while the vapor deposition rate from each of evaporation sources of In, Ga and Se was controlled to set the atomic composition ratio of Ga/(In + Ga) to about 0.30, a thin film composed of In, Ga and Se was deposited at a substrate temperature of 400°C. Next, a film composed of Cu and Se was deposited thereon at a substrate temperature of 550°C while the vapor deposition rate from each of evaporation sources of Cu and See was controlled. Finally, a thin film composed of In, Ga and Se was deposited thereon at a substrate temperature of 550°C while the vapor deposition rate from each of evaporation sources of In, Ga and Se was controlled. The thickness of the thus-obtained CuInGaSe$_2$ film was about 2.0 $\mu$m.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by a MOCVD method.

Next, an Al-added ZnO film as a transparent conductive film was deposited into a thickness of about 200 nm thereon by a MOCVD method.

Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm$^2$. As a result, a conversion efficiency of 10.2% was obtained. The result indicates that even when the anodized aluminum substrate according to the present invention is used to form a solar cell, the resulting solar cell shows sufficient photoelectric conversion efficiency.

Example 4

The sample 1-8 of Example 1 according to the invention was used as a substrate. After a Mo layer was formed on the anodized aluminum substrate by RF sputtering (high frequency sputtering), a NaF layer was formed thereon by RF sputtering, and a Mo layer was further formed thereon by RF sputtering. The resulting Mo/NaF/Mo multilayer film had a thickness of about 1.0 $\mu$m.

A Cu-Ga alloy and metal In were used as targets to form a laminate film composed of a Cu-Ga film and an In film on the above-described Mo by sputtering. The Ga content by percentage in the Cu-Ga alloy was 30% by atom. The sputtering was conducted in an Ar gas atmosphere.

Next, this substrate, in which the Cu-Ga film and the In film were laminated, was put into an electric furnace, and then heated to about 520°C in an atmosphere containing 1% by volume of H$_2$Se gas. By this treatment, a CuInGaSe$_2$ thin film was formed. The thickness of the resultant CuInGaSe$_2$ film was about 2.0 $\mu$m.

Plural semiconductor layers were then formed as window layers. First, an about 50 nm thick CdS film was deposited by a chemical deposition method. The chemical deposition method was performed by heating at about 80°C an aqueous solution containing Cd nitrate, thiourea and ammonia and immersing the light absorption layer in the aqueous solution. An about 80 nm thick ZnO film was further formed on the CdS film by a MOCVD method.

Next, an Al-added ZnO film as a transparent conductive film was deposited into a thickness of about 200 nm thereon by a MOCVD method.

Finally, Al was vapor-deposited to form an extraction electrode, so that a solar cell was obtained.

The characteristics of the resulting solar cell were evaluated using simulated sunlight under the conditions of an Air Mass (AM) of 1.5 and 100 mW/cm$^2$. As a result, a conversion efficiency of 9.7% was obtained. The result indicates that even when the anodized aluminum substrate according to the present invention is used to form a solar cell, the resulting solar cell shows sufficient photoelectric conversion efficiency.

INDUSTRIAL APPLICABILITY

The substrate for a solar cell of the invention is a substrate for a solar cell which is lighter in weight and higher in thermal conductivity and is less easily cracked than glass substrates, and which has flexibility and very good insulating property. Accordingly, the substrate for a solar cell of the invention can be used suitably for a solar cell.

Having described our invention as related to the present embodiments, it is our intention that the invention not be limited by any of the details of the description, unless otherwise specified, but rather be construed broadly within its spirit and scope as set out in the accompanying claims.

This non-provisional application claims priority on Patent Application No. 2007-255691 filed in Japan on September 28, 2007 and Patent Application No. 2008-088955 filed in Japan on March 30, 2008, each of which is entirely herein incorporated by reference.

**Claims**

1.  A substrate for a solar cell, comprising:

    a metal substrate, and
    an insulating anodic oxidation film provided on the metal substrate,

    wherein the thickness To of the anodic oxidation film and the thickness $T_B$ of a barrier layer of the anodic oxidation film are inside of or on the boundary lines of a region I surrounded by the point A ($T_O$ = 0.01 $\mu$m, $T_B$ = 0.01 $\mu$m), the point B (To = 2 $\mu$m, $T_B$ = 2 $\mu$m), the point C ($T_O$ = 100 $\mu$m, $T_B$ = 2 $\mu$m) and the point D ($T_O$ = 100 $\mu$m, $T_B$ = 0.01 $\mu$m) shown in FIG. 1.

2.  The substrate for a solar cell according to Claim 1, wherein the metal substrate is a substrate containing at least one metal selected from the group consisting of aluminum, zirconium, titanium, magnesium, copper, niobium and tantalum.

3.  The substrate for a solar cell according to Claim 1 or 2, wherein the metal substrate is a substrate containing a metal selected from the group consisting of aluminum, titanium and copper.

4.  The substrate for a solar cell according to any one of Claims 1 to 3, wherein the thickness To of the anodic oxidation film formed on the metal substrate and the thickness $T_B$ of the barrier layer of the anodic oxidation film are inside of or on the boundary lines of a region II surrounded by the point A' (To = 0.05 $\mu$m, $T_B$ = 0.05 $\mu$m), the point B' ($T_O$ = 1 $\mu$m, $T_B$ = 1 $\mu$m), the point C' ($T_O$ = 50 $\mu$m, $T_B$ = 1 $\mu$m) and the point D' (To = 50 $\mu$m, $T_B$ = 0.05 $\mu$m) shown in FIG. 1.

5.  The substrate for a solar cell according to any one of Claims 1 to 4, wherein the metal substrate is an aluminum substrate.

6.  The substrate for a solar cell according to any one of Claims 1 to 5, wherein the anodic oxidation film is formed on both surfaces of the metal substrate.

7.  The substrate for a solar cell according to any one of Claims 1 to 6, wherein the thickness of the barrier layer is ensured by conducting pore-sealing treatment.

8.  A solar cell, comprising:

    the substrate for a solar cell according to any one of Claims 1 to 7, and
    a photoelectric conversion layer provided on the substrate for a solar cell,

wherein the photoelectric conversion layer comprises a semiconductor layer comprising at least one Group Ib element, at least one Group IIIb element, and at least one VIb element.

9. The solar cell according to Claim 8, wherein the semiconductor layer comprises at least one element selected from the group consisting of copper (Cu), silver (Ag), indium (In), gallium (Ga), sulfur (S), selenium (Se), and tellurium (Te).

[FIG. 1]

[FIG. 2]

[FIG. 3]

[FIG. 4]

(a)

MO — 200
SLG — 100

(b)

CIGS(P⁻) — 300
MO — 200
SLG — 100

(c)

ZnO(n⁺) — 500
— 400(CdS)
CIGS(P⁻) — 300
MO — 200
SLG — 100

(d)

B

ZnO — 500
— 400(CdS)
A CIGS — 300
MO — 100
SLG — 100

[FIG. 5]

Cu(In₁₋ₓGaₓ)Se₂ (CIGS) is a mixed crystal of CuInSe₂ and CuGaSe₂.

The band gap can be controlled to fall within the range of 1.04 to 1.68 eV by changing the Ga concentration x.

Other mixed crystal: Cu(InAl)Se₂, Ag(InGa)Se₂, CuIn(S,Se)₂, AgIn(S,Se)₂

For upper cell
Ideal band gap for single junction
For lower cell

Conversion efficiency

## INTERNATIONAL SEARCH REPORT

| International application No. |
| --- |
| PCT/JP2008/067559 |

A. CLASSIFICATION OF SUBJECT MATTER
*H01L31/04*(2006.01)i

According to International Patent Classification (IPC) or to both national classification and IPC

B. FIELDS SEARCHED

Minimum documentation searched (classification system followed by classification symbols)
H01L31/04-31/078

Documentation searched other than minimum documentation to the extent that such documents are included in the fields searched
Jitsuyo Shinan Koho         1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)
WPI, JSTPlus(JDreamII)

C. DOCUMENTS CONSIDERED TO BE RELEVANT

| Category* | Citation of document, with indication, where appropriate, of the relevant passages | Relevant to claim No. |
| --- | --- | --- |
| X | JP 59-152675 A (Sumitomo Electric Industries, Ltd.), 31 August, 1984 (31.08.84), Full text; all drawings (Family: none) | 1-9 |
| X | JP 2007-250376 A (Nippon Foil Mfg. Co., Ltd.), 27 September, 2007 (27.09.07), Full text; all drawings (Family: none) | 1-7 |
| Y | | 8,9 |
| X | JP 11-229185 A (Kobe Steel, Ltd.), 24 August, 1999 (24.08.99), Full text; all drawings (Family: none) | 1-7 |
| Y | | 8,9 |

| ☒ Further documents are listed in the continuation of Box C. | ☐ See patent family annex. |
| --- | --- |

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search 21 October, 2008 (21.10.08) | Date of mailing of the international search report 28 October, 2008 (28.10.08) |
| --- | --- |
| Name and mailing address of the ISA/ Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/067559

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | WO 2003/007386 A1 (Mid-West Research Institute), 23 January, 2003 (23.01.03), Full text; all drawings & US 2005/0074915 A1 | 8,9<br>1-7 |
| A | JP 62-089369 A (Matsushita Electric Industrial Co., Ltd.), 23 April, 1987 (23.04.87), Full text; all drawings (Family: none) | 1-9 |

Form PCT/ISA/210 (continuation of second sheet) (April 2007)

## INTERNATIONAL SEARCH REPORT

| International application No. |
| --- |
| PCT/JP2008/067559 |

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:
The technical feature common to all the claims is the invention of claim 1.
The international search, however, has revealed that the invention of claim 1 is not novel since it is disclosed in JP 59-152675 A, JP 2007-250376 A and JP 11-229185 A.
Consequently, the invention of claim 1 is not a special technical feature within the meaning of PCT Rule 13.2, second sentence.
The inventions of claims 1-9 therefore do not satisfy the requirement of unity of invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006080370 A
- JP 2006295035 A
- JP 2000349320 A
- JP 2003096584 A
- JP 2007030146 A
- JP 3044377 B
- JP 3082040 B
- GB 526854 A
- GB 552638 A
- JP 128891 A
- JP 13004757 B
- JP 10121292 A
- JP 2001105400 A
- JP 2003129288 A
- JP 2000315785 A
- JP 6001090 A
- JP 5179482 A
- JP 5202496 A
- JP 2007123725 A
- JP 9074065 A
- JP 9074213 A
- JP 2007527121 A
- WO 2004090995 A
- JP 2002343987 A
- JP 9219530 A
- JP 8222750 A
- WO 03069684 A
- JP 2006210424 A
- JP 5315633 A
- JP 6252433 A
- JP 9503346 A
- JP 2003188396 A
- JP 9172193 A
- JP 10135501 A
- JP 2000012883 A
- JP 9055378 A
- JP 10074966 A
- JP 10074967 A
- JP 2004079858 A
- JP 2006165386 A
- JP 11312817 A
- JP 2007266626 A
- JP 2003318424 A
- JP 2007528600 A
- JP 2007109842 A
- JP 2007123532 A
- JP 2007201304 A
- JP 2007317858 A
- JP 2007317868 A
- JP 2007317879 A
- JP 2007317885 A
- JP 2004115356 A
- JP 11312815 A
- JP 2007123721 A
- JP 11284211 A
- JP 2007255691 A
- JP 2008088955 A

### Non-patent literature cited in the description

- Aluminum Hyomen-gijutsu Binran. Nihon Keikinzoku Shuppan, 1980
- Aluminum Hyomen-gijutsn Binran. Nihon Keikinzoku Shuppan, 1980
- Jitsumu no tameno Atarashii Kenma Gijutsu. Ohmsha, Ltd, 1992, 55-93
- New Practical Technology for Polishing. Ohmsha, Ltd, 1992, 55-93
- Aluminum no Hyomen-Shori. Uchida Rokakuho Publishing Co., Ltd, 1980, 36
- *Met. Ind.,* 1951, vol. 78, 89
- Aluminum Gijutsu Binran. Kallos Publishing Co., Ltd, 1996
- Surface Treatment of Aluminium. Uchida Rokakuho Publishing Co., Ltd, 1980, 47
- Handbook of Aluminum Technology. Kallos Publishing Co., Ltd, 1996
- **Kazuo Maeda.** Hajimete no Handotai-Seizn-Soti. Kogyo Chosakai Publishing Inc, March 1999, 171
- Dai-108-kai Koen-Taikai Yoshi-Shu. The Surface Finishing Society of Japan, vol. 18-B2, 76-77
- *J. Electrochem. Soc.,* 1997, vol. 144 (5), L128
- *Jpn. J. Appl. Phys.,* 1996, vol. 35 (1B), L126
- *Appl. Phys. Lett.,* 10 November 1997, vol. 71 (19), 2771
- **J. R. Tuttle ; J. S. Ward ; A. Duda ; T. A. Berens ; M. A. Contreras ; K. R. Ramanathan ; A. L. Tennant ; J. Kaene ; E. D. Cole ; K. Emery.** *Mat. Res. Soc. Symp. Rroc.,* 1996, vol. 426, 143

- **L. Stolt et al.** *Proc. 13th ECPVSEC (1995, Nice),* 1995, 1451
- **W. E. Devaney ; W. S. Chen ; J. M. Stewart ; R. A. Mickelsen.** *IEEE Trans. Electron. Devices,* vol. 37, 428
- **H. Miyazaki ; T. Miyake ; Y. Chiba ; A. Yamada ; M. Konagai.** *Phys. Stat. Sol. (a),* 2006, vol. 203, 2603
- **B. M. Basol ; V. K. Kapur ; C. R. Leidholm ; R. Roe ; A. Halani ; G. Norsworthy.** NREL/SNL Photovoltaics Prog. Rev. Proc. 14th Conf.-A Joint Meeting. *AIP Conf. Proc.,* 1996, 394
- **T. Nakada ; R. Ohnishi ; A. Kunioka.** CuInSe2-Based Solar Cells by Se-Vapor Selenization from Se-Containing Precursors. *Solar Energy Materials and Solar Cells,* 1994, vol. 35, 204-214
- **T. Nakada ; K. Yuda ; A. Kunioka.** Thin Films of CuInSe2 Produced by Thermal Annealing of Multilayers with Ultra-Thin Stacked Elemental Layers. *Proc. Of 10th European Photovoltaic Solar Energy Conference,* 1991, 887-890
- **K. Kushiya ; I. Sugiyama ; M. Tachiyuki ; T. Kase ; Y. Nagoya ; O. Yamase ; H. Takeshita.** Tech. Digest 9th Photovoltaic Science and Engineering Conf. Miyazaki, 1996. *Intn. PVSEC-9, Tokyo,* 1996, 149
- **J. H. Ermer ; R. B. Love ; A. K. Khanna ; S. C. Lewis ; F. Cohen.** CdS/CuInSe2 Junctions Fabricated by DC Magnetron Sputtering of Cu2Se and In2Se. *Proc. 18th IEEE Photovoltaic Specialists Conf.,* 1985, 1655-1658
- **T. Nakada ; K. Migita ; A. Kunioka.** Polycrystalline CuInSe2 Thin Films for Solar Cells by Three-Source Magnetron Sputtering. *Jpn. J. Appl. Phys.,* 1993, vol. 32, L1169-L1172
- **T. Nakada ; M. Nishioka ; A. Kunioka.** CuInSe2 Films for Solar Cells by Multi-Source Sputtering of Cu, In, and Se-Cu Binary Alloy. *Proc. 4th Photovoltaic Science and Engineering Conf.,* 1989, 371-375
- **T. Nakada ; K. Migita ; S. Niki ; A. Kunioka.** Microstructural Characterization for Sputter-Deposited CuInSe2 Films and Photovoltaic Devices. *Jpn. Appl. Phys.,* 1995, vol. 34, 4715-4721
- **A. Rockett ; T. C. Lommansson ; L. C. Yang ; H. Talieh ; P. Campos ; J. A. Thornton.** *Proc. 20th IEEE Photovoltaic Specialists Conf.,* 1988, 1505
- **S. Isomura ; H. Kaneko ; S. Tomioka ; I. Nakatani ; K. Masumoto.** *Jpn. J. Appl. Phys.,* 1980, vol. 19 (19-3), 23
- **T. Wada ; Y. Matsuo ; S. Nomura ; Y. Nakamura ; A. Miyamura ; Y. Chia ; A. Yamada ; M. Konagai.** *Phys. Stat. Sol (a),* 2006, vol. 203, 2593
- **T. Dullweber.** A new approach to high-efficiency solar cells by band gap grading in Cu(In,Ga)Se2 chalcopyrite semiconductors. *Solar Energy Materials & Solar Cells,* 2001, vol. 67, 145-150
- **John A. Thornton ; David W. Hoffman.** *J. Vac. Sci. Technol.,* January 1977, vol. 14 (1
- **John H. Schofield et al.** *Thin Solid Films,* 1995, vol. 260, 26-31
- **David F. Dawson-Elli.** Substrate Influences On CIS Device Performance. *Proc.1st World Conference of Photovoltaic Energy Conversion,* 1995, 152-155
- **C.Jensen.** The Study of Base Electrode/Substrate Interactions By Use of Air Anneal Imaging. *Proc.13th European photovoltaic Solar Energy Conference,* 1995
- **V.Probst.** Large Area CIS Formation By Rapid Thermal Processing Of Stacked Elemental Layers. *Proc. 17th European Photovoltaic Solar Energy Conference,* 2002, 1005-1010
- **V. Probst.** Advanced Stacked a CIS Formation By Rapid Thermal Processing Of Stacked Elemental Layer Process For Cu(InGa)Se2 Thin Film Photovoltaic Devices. *Mat. Res. Soc. Symp. Proc.,* 1996, vol. 426, 165-176
- **J. Holz et al.** *Proc. 12th European Photovoltaic Solar Energy Conference,* 1994, 1592-1595
- **R. J. Araujo.** Sodium Redistribution Between Oxide Phases. *Journal of Non-Crystalline Solids,* 1996, vol. 197, 154-163